# FASCICULE DE BREVET EUROPEEN

(11) **EP 2 776 515 B1**
(45) Date de publication et mention de la délivrance du brevet: **28.08.2019**
(21) Numéro de dépôt: 12783615.3
(22) Date de dépôt: 12.11.2012
(51) Int. Cl.: C09B 57/00, H01L 51/00

(54) **COLORANT ORGANIQUE ET SES UTILISATIONS DANS LES CELLULES PHOTOVOLTAÏQUES**
ORGANISCHER FARBSTOFF UND SEINE VERWENDUNG FÜR PHOTOVOLTAIKZELLEN
ORGANIC COLOURANT AND USES THEREOF IN PHOTOVOLTAIC CELLS

(30) Priorité: 10.11.2011 FR 1160276; 21.11.2011 FR 1160600
(43) Date de publication de la demande: 17.09.2014
(73) Titulaire: Commissariat à l'Énergie Atomique et aux Énergies Alternatives, 75015 Paris (FR)
(72) Inventeur: DEMADRILLE, Renaud, F-38120 Saint-Egrève (FR); KERVELLA, Yann, F-38160 Saint Verand (FR)
(74) Mandataire: Ahner, Philippe
(86) Numéro de dépôt international: PCT/EP2012/072401
(87) Numéro de publication internationale: WO 2013/068588

(56) Documents cités:
- CN-A- 101 029 182
- CN-A- 101 407 639
- CN-A- 101 475 568
- CN-A- 102 002 037
- JP-A- 2007 149 570
- US-A1- 2010 076 205
- US-A1- 2010 168 444
- US-A1- 2010 174 095
- JULIEN PREAT ET AL: "Improvement of the efficiency of thiophene-bridged compounds for dye-sensitized solar cells", CHEMICAL PHYSICS, vol. 376, no. 1-3, 1 novembre 2010 (2010-11-01), pages 56-68, XP055030418, ISSN: 0301-0104, DOI: 10.1016/j.chemphys.2010.08.001

## Description

### DOMAINE TECHNIQUE

La présente invention appartient au domaine de l'énergie photo-électrique et, notamment, au domaine des cellules et dispositifs photovoltaïques.

Plus particulièrement, la présente invention propose une famille de composés purement organiques, basés sur des chromophores pi-conjugués et leur utilisation comme photo-sensibilisateurs d'électrode dans des dispositifs photovoltaïques.

### ÉTAT DE LA TECHNIQUE ANTÉRIEURE

Actuellement les meilleures cellules solaires hybrides sont fabriquées à partir d'un semi-conducteur massif nanostructuré qui est généralement un oxyde de titane transparent. La surface de cet oxyde est fonctionnalisée par greffage de colorants photosensibles très souvent organométalliques. Un électrolyte généralement liquide, mais qui peut être également un gel ou un solide semi-conducteur de type p, vient compléter le système, emprisonné entre deux électrodes transparentes. Ce type de cellule permet la fabrication de panneaux semi-transparents de couleurs variées en fonction du colorant choisi.

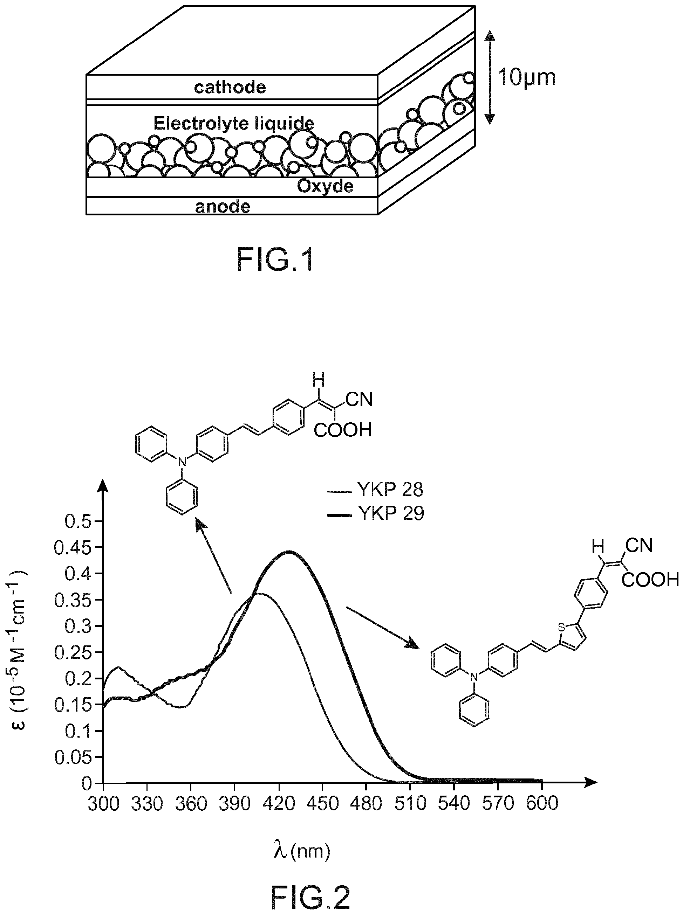

Dans ce type de cellules, les photons solaires sont absorbés par les colorants et les charges électroniques photogénérées sont ensuite injectées à partir de ces colorants dans l'oxyde dont la fonction est d'acheminer les électrons vers l'électrode. La Figure 1 est une schématisation des différents constituants d'une telle cellule photovoltaïque [1].

En résumé, dans ces cellules, la séparation des charges photogénérées dans le colorant intervient à l'interface entre le colorant, le semi-conducteur et l'électrolyte ce qui fait du colorant un des éléments essentiels du dispositif.

Les colorants les plus efficaces dans ce domaine sont des complexes organométalliques généralement à base de ruthénium et les rendements de conversion sont compris entre 11 et 12% **[2].** Le principal désavantage des cellules hybrides, qui comptent parmi les plus efficaces dans le domaine des cellules alternatives aux technologies dites classiques, réside dans le fait qu'un colorant organométallique à base de ruthénium est extrêmement couteux (en 2011, le gramme de complexe vaut environ 800 à 1000 euros). De plus, le ruthénium fait partie des 9 métaux les plus rares sur terre entraînant de fait un prix de cette matière première extrêmement volatile. Enfin, le ruthénium est un élément toxique et certains de ses dérivés sont identifiés comme cancérigènes ou mutagènes.

Ainsi, le remplacement des complexes de ruthénium dans les cellules solaires par des composés organiques peu coûteux et moins toxiques dont les propriétés optoélectroniques peuvent être modulées facilement est donc souhaitable pour permettre aux cellules solaires sensibilisées à colorants de se développer à large échelle.

Récemment des colorants se présentant sous forme de molécules purement organiques ont été développés et employés de manière efficace (entre 8 et 10%) dans des cellules photovoltaïques **[3].**

De manière générale, ces sensibilisateurs doivent impérativement posséder des niveaux énergétiques dont les positions sont bien ajustées au potentiel redox de l'électrolyte et au niveau de la bande de conduction de l'oxyde. Mais un point crucial concerne les propriétés d'absorption des molécules qui doivent être capables d'absorber, de manière intense et sur une large gamme de longueurs d'ondes, les photons émis par le soleil. De plus, la fonction d'ancrage que ce dernier doit comporter pour se fixer de manière stable à la surface de l'oxyde est également importante : elle doit être adaptée à la surface de l'oxyde.

La plupart des composés organiques employés sont conçus et construits selon le schéma suivant : 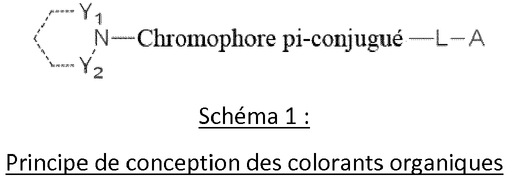 Ils présentent donc :
- un segment électro-donneur (eD) à propriétés redox stables i.e. une fonction redox de type arylamine (-N(Y₁)(Y₂)) qui permet au colorant d'être réduit plus facilement par l'électrolyte ;
- une partie pi-conjuguée, plus au moins étendue, qui permet d'absorber efficacement les photons solaires et qui permet aux charges d'être évacuées dans l'oxyde plus facilement ;
- et enfin une fonction d'ancrage à caractère électro-accepteur (A) de type carboxylique ou cyano-acrylique qui est reliée au système pi-conjugué de la molécule par un espaceur (L) comportant, de préférence, une fonction éthylénique.

Cette fonction d'ancrage permet le greffage et la sensibilisation des particules en facilitant le transfert électronique des noyaux aromatiques électrodéficients vers l'oxyde. Il faut toutefois noter que la fonction d'ancrage de type carboxylique est particulièrement bien adaptée pour le greffage sur TiO₂ mais moins pour le ZnO. En effet, des risques d'attaque chimique du ZnO et de dégradation de la couche sont à craindre si on utilise un groupe carboxylique **[4].**

Les règles de conception de ces colorants sont exposées dans la revue de Ooyama et Harima **[5].** Sur la base de ces règles, de nombreux colorants ont récemment été conçus et publiés ou brevetés dans le domaine des cellules photovoltaïques mais certaines limitations existent avec les colorants actuels.

Afin d'augmenter les performances des colorants en dispositifs, il apparaît crucial d'améliorer leurs propriétés d'absorption, c'est-à-dire d'augmenter la gamme spectrale d'absorption des photons, idéalement dans la partie visible du spectre solaire, et d'augmenter les coefficients d'absorption molaire des molécules. En résumé les molécules de colorant doivent absorber de manière intense et sur une gamme large les photons solaires.

La stratégie visant à augmenter les coefficients d'absorption des colorants a été employée, pour la première fois, en 2005, avec des complexes de ruthénium. En modifiant les ligands hétéroleptiques, c'est-à-dire en introduisant des unités vinylènes ou des chromophores qui servent d'antennes sur ces derniers, une augmentation de leurs coefficients d'absorption a été observée **[6]**. Il en résulte une amélioration des propriétés photovoltaïques du système.

De nombreux travaux existent pour tenter d'améliorer les coefficients d'absorption molaire des composés à base de ruthénium. Toutefois, de manière surprenante, il n'existe aucun travail visant à spécifiquement améliorer les coefficients d'absorption molaire des colorants organiques existants.

Ainsi, les coefficients d'absorption molaire des colorants purement organiques actuellement utilisés sont encore faibles. C'est par exemple le cas des colorants décrits dans la demande internationale WO 2009/109499 **[7]** dont les coefficients d'absorption molaire sont tous inférieurs à 48000 M⁻¹.cm⁻¹ et les rendements de conversion sont tous inférieurs à 5,1%, lorsque les cellules sont fabriquées avec un électrolyte liquide et un co-adsorbant de type acide chenodéoxycholique dont la structure est reprise ci-après :

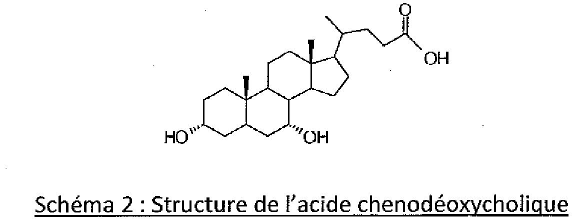

D'autres exemples sont rapportés dans la littérature **[8-10].** Toutefois, le même problème est rencontré avec des coefficients d'absorption molaire qui sont inférieurs à 40000 M⁻¹.cm⁻¹ et les efficacités en cellules fabriquées avec une électrode de TiO₂ et un électrolyte liquide qui sont inférieures à 4,5%.

En 2008, un article a rapporté l'emploi de colorant à base de EDOT (3,4-éthylèndioxythiophène) présentant des spectres largement décalés dans le visible et, malgré, là encore, des coefficients d'absorption molaire faibles, des rendements assez élevés (de l'ordre de 7%) ont été obtenus **[11].** En employant cette stratégie, Wang rapporte, en 2010, un colorant avec des coefficients d'absorption molaire supérieurs à 50000 M⁻¹.cm⁻¹ et un rendement en cellule supérieur à 7% **[12].**

Il existe des colorants présentant des coefficients d'absorption molaire supérieurs, pouvant aller jusqu'à 80000 M⁻¹.cm⁻¹, mais ces colorants présentent des absorptions très faibles dans le visible correspondant à la gamme spectrale comprise entre 400 et 800 nm et des rendements modérés (de l'ordre de 6%) en dispositifs **[13].**

La demande de brevet US 2010/76205 propose des colorants organiques pour cellules photovoltaïques qui répondent à la formule : (B¹)(B²)N-A¹-A²-A³-CH=C(CN)(COOH) dans laquelle A¹, A² et A³ représentent chacun indépendamment un groupe 1,4-phénylène ou 2,5-thiophène substitué ou non substitué, et B¹ et B² représentent chacun indépendamment un groupe aryle substitué ou non substitué.

La demande de brevet CN 102 002 037 concerne des composés comprenant une triphénylamine et leur utilisation notamment pour la préparation d'un matériel de conversion photo-électrique. Parmi les composés décrits, se trouve le composé 1.3 répondant à la formule ci-après et dont le pourcentage d'efficacité de conversion photoélectrique, dans un dispositif photovoltaïque à électrolyte solide ou liquide est de 2,77% et de 4,83% respectivement :

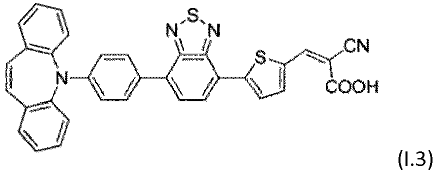

En l'état actuel, il existe donc un réel besoin de disposer de colorants organiques qui présentent un spectre d'absorption le plus large possible et plus particulièrement dans la partie visible du spectre solaire correspondant à la gamme spectrale comprise entre 400 et 800 nm et un coefficient d'absorption molaire élevé afin d'augmenter les performances des colorants en dispositif photovoltaïque.

### EXPOSÉ DE L'INVENTION

La présente invention permet de résoudre tout ou partie des problèmes techniques listés ci-dessus.

En effet, les travaux des inventeurs ont permis de synthétiser de nouveaux colorants organiques et, plus particulièrement, des chromophores pi-conjugués compris dans ces derniers présentant des associations de groupements fonctionnels particuliers tels que des thiophènes, des sélénophènes et des furannes. De tels colorants utilisés comme photo-sensibilisateurs dans des dispositifs photovoltaïques à base d'oxyde métallique permettent (i) de décaler dans la partie visible du spectre solaire la bande d'absorption maximale (λmax), (ii) d'augmenter de manière significative le coefficient d'absorption molaire et (iii) d'améliorer les rendements de conversion photovoltaïque.

Ainsi, la présente invention concerne un colorant organique tel que défini dans la revendication 1 répondant à la structure (I) suivante :

eD - chromophore pi-conjugué - L - A (I)

avec
- eD représente un segment électro-donneur,
- L représente une liaison covalente ou un segment espaceur et notamment un segment espaceur pi-conjugué,
- A représente un segment électro-attracteur apte à former une liaison covalente avec un semi-conducteur,
   dans lequel le chromophore pi-conjugué comprend au moins deux cycles aromatiques dont au moins un est un cycle de type thiophène
   et dans lequel ce chromophore présente au moins un motif choisi parmi les motifs (X), (XI) et (XII) ci-après, les autres motifs ne faisant pas partie de l'invention : 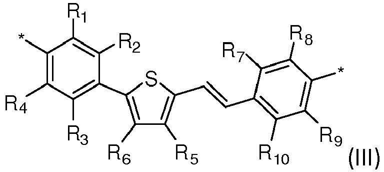 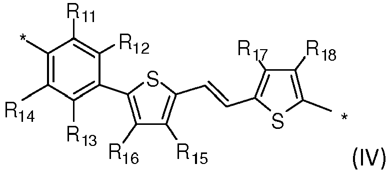 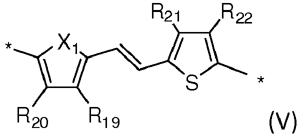 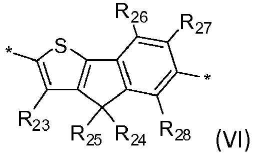 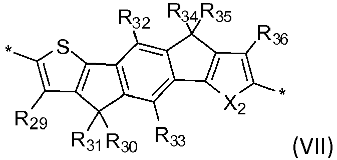 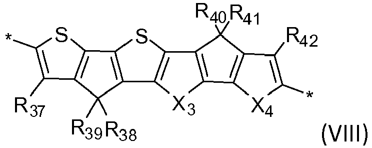 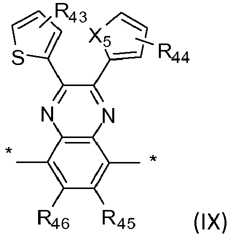 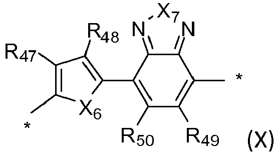 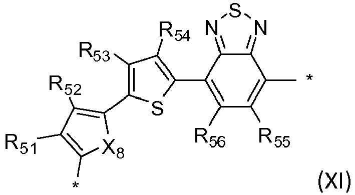 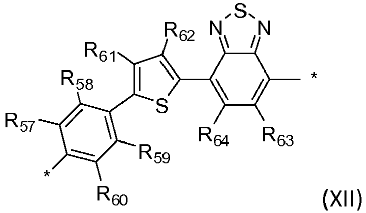 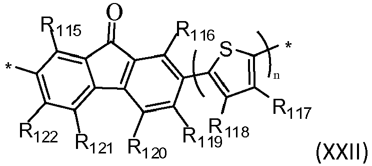
dans lesquels
- les radicaux R₁ à R₆₄ et R₁₁₅ à R₁₂₂, identiques ou différents, représentent un hydrogène, un groupement alkyle éventuellement substitué ou un groupement aryle éventuellement substitué, les radicaux R₂₄ et R₂₅ ; les radicaux R₃₀ et R₃₁, les radicaux R₃₄ et R₃₅, les radicaux R₃₈ et R₃₉ et les radicaux R₄₀ et R₄₁ pouvant former ensemble un groupement =O ou =(R₆₅)(R₆₆) avec les groupements R₆₅ et R₆₆, identiques ou différents, représentant un hydrogène, un groupement alkyle éventuellement substitué ou un groupement aryle éventuellement substitué et les radicaux R₄₆ et R₄₅ pouvant former ensemble un groupement pontant ;
- X₁ est soit Se soit O ;
- X₂, X₃, X₄, X₅ et X₈, identiques ou différents sont choisis parmi S, Se et O,
- X₆ et X₇ sont tels que l'un des deux représente S et l'autre est soit Se, soit O et
- n représente 1, 2, 3 ou 4,
   à l'exception des colorants organiques (3-11) et (3-12) décrits dans la demande de brevet japonais 2009-269987A i.e. des colorants organiques de formules (3-11) et (3-12) :

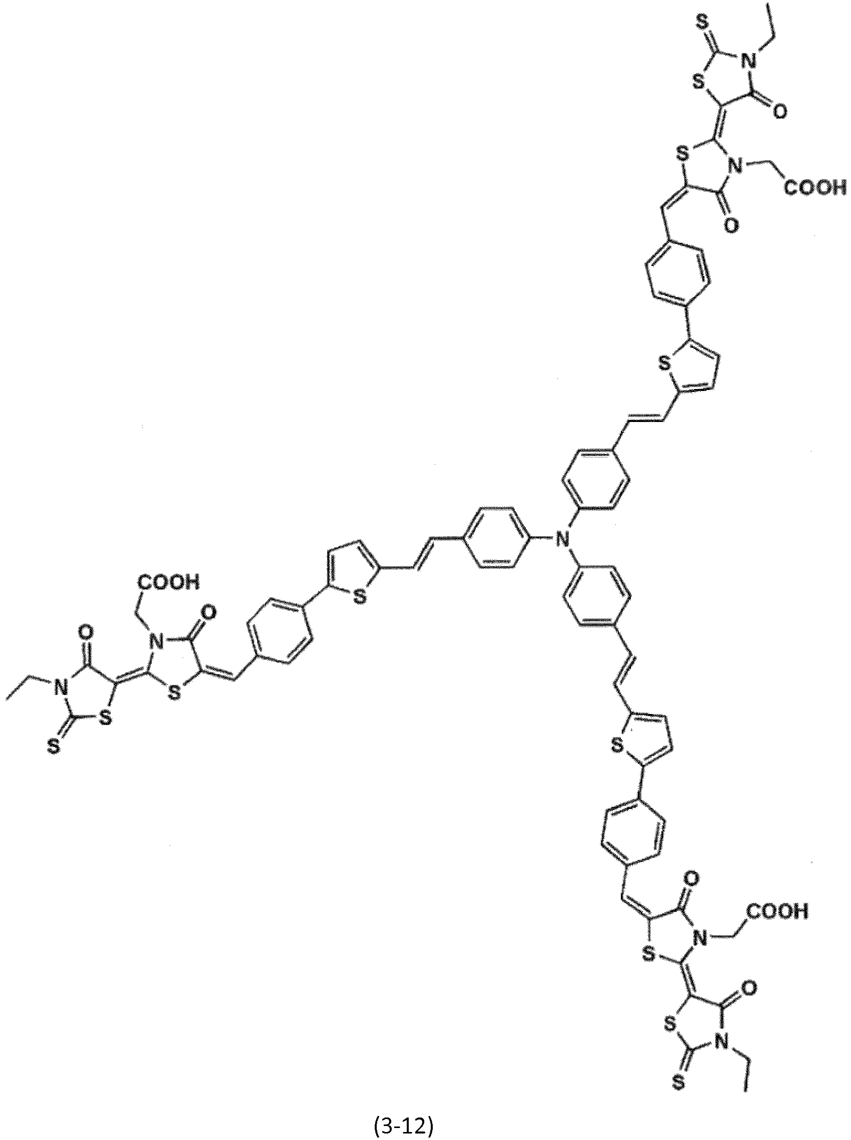

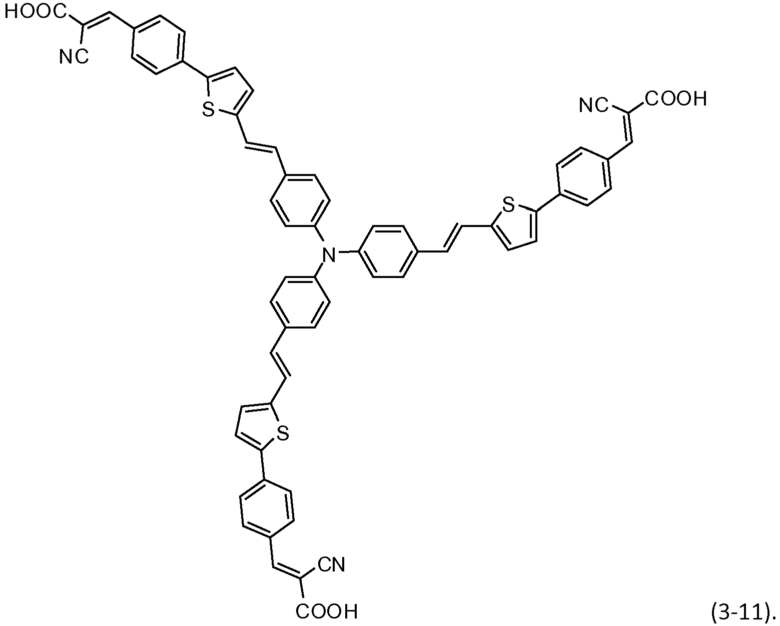

Par « groupement alkyle », on entend, dans le cadre de la présente invention, un groupement alkyle, linéaire ou ramifié, cyclique comprenant de 1 à 20 atomes de carbone, notamment de 1 à 15 atomes de carbone et en particulier, de 1 à 10 atomes de carbone, pouvant comporter éventuellement au moins un hétéroatome, comme, par exemple, un groupe méthyle, éthyle, n-propyle, isopropyle, butyle, isobutyle, *sec*-butyle, *tert*-butyle, pentyle, isopentyle, hexyle, heptyle ou un octyle.

Par « groupement aryle », on entend, dans le cadre de la présente invention, un groupement aryle à un cycle ou plusieurs cycles fusionnés ou reliés par une liaison unique ou par un groupe hydrocarboné, chaque cycle ayant de 4 à 20 atomes de carbone, notamment de 4 à 14 atomes de carbone, en particulier, de 4 à 8 atomes de carbone et pouvant comporter éventuellement au moins un hétéroatome. A titre d'exemples de groupe aryle, on peut citer les groupes phényle, biphényle, naphtyle, anthracényle, cyclopentadiényle, pyrényle, tétrahydronaphtyle, furanyle, pyrrolyle, thiophényle, oxazolyle, pyrazolyle, isoquinolinyle, thiazolyle, imidazolyle, triazolyle, pyridinyle, pyranyle, quinolinyle, pyrazinyle et pyrimidinyle.

Par « groupement pontant », on entend, dans le cadre de la présente invention, un groupement hydrocarboné de 1 à 50 atomes de carbone et notamment de 2 à 40 atomes de carbone, comprenant éventuellement un hétéroatome ou plusieurs hétéroatomes identiques ou différents et/ou une (ou plusieurs) insaturation(s) éthylénique(s), ledit groupement étant éventuellement substitué.

Par « groupement alkyle substitué », « groupement aryle substitué » ou « groupement hydrocarboné substitué », on entend, dans le cadre de la présente invention, un groupement alkyle, aryle ou hydrocarboné tel que précédemment défini substitué par un groupement ou plusieurs groupements identiques ou différents choisi(s) parmi un halogène ; une amine ; une diamine ; un carboxyle ; un carboxylate ; un aldéhyde; un ester; un éther; un hydroxyle ; un halogène; un aryle éventuellement substitué tel que précédemment défini et notamment tel qu'un phényle, un benzyle ou un naphthyle ; un alkyle éventuellement substitué tel que précédemment défini et notamment tel qu'un méthyle, un éthyle, un propyle ou un hydroxypropyle ; un amide ; un sulfonyle ; un sulfoxyde ; un acide sulfonique ; un sulfonate ; un acyle ; un vinyle ; un hydroxyle; un époxy; un phosphonate ; un isocyanate ; un thiol ; un glycidoxy ; un acryloxy ; un thiophène ; un furanne ; un sélénophène et leurs sels.

Il est évident que les groupements aryles éventuellement substitués mis en oeuvre dans la présente invention couvrent également des chromophores pi-conjugués et notamment des chromophores pi-conjugués tels que décrits dans la présente invention.

Par « hétéroatome », on entend, dans le cadre de la présente invention, un atome choisi dans le groupe constitué par azote, oxygène, phosphore, soufre, silicium, fluor, chlore et brome.

Par « halogène », on entend, dans le cadre de la présente invention, un atome choisi dans le groupe constitué par fluor, chlore, iode et brome.

Parmi les motifs (X), des motifs avantageux sont ceux dans lesquels X₆ représente S, X₇ représente Se (ou O), les groupements R₄₉ et R₅₀ sont identiques et tels que précédemment définis et représentent notamment un hydrogène, les groupements R₄₇ et R₄₈ pouvant être identiques ou différents. Dans une 1^{ère} forme de mise en oeuvre de ces motifs (X) avantageux, les groupements R₄₇ et R₄₈ sont identiques et tels que précédemment définis et notamment représentent un hydrogène. Dans une 2^{nde} forme de mise en oeuvre de ces motifs (X) avantageux, les groupements R₄₇ et R₄₈ sont différents avec le groupement R₄₇ (ou R₄₈) représente un hydrogène et le groupement R₄₈ (ou R₄₇) représente un groupement alkyle éventuellement substitué ou un groupement aryle éventuellement substitué.

En variante, parmi les motifs (X), des motifs avantageux sont ceux dans lesquels X₇ représente S, X₆ représente Se (ou O), les groupements R₄₉ et R₅₀ sont identiques et tels que précédemment définis et représentent notamment un hydrogène, les groupements R₄₇ et R₄₈ pouvant être identiques ou différents. Dans une 1^{ère} forme de mise en oeuvre de ces motifs (X) avantageux, les groupements R₄₇ et R₄₈ sont identiques et tels que précédemment définis et notamment représentent un hydrogène. Dans une 2^{nde} forme de mise en oeuvre de ces motifs (X) avantageux, les groupements R₄₇ et R₄₈ sont différents avec le groupement R₄₇ (ou R₄₈) représente un hydrogène et le groupement R₄₈ (ou R₄₇) représente un groupement alkyle éventuellement substitué ou un groupement aryle éventuellement substitué.

Parmi les motifs (XI), des motifs avantageux sont ceux dans lesquels X₈ représente S (ou Se ou O), les groupements R₅₅ et R₅₆ sont identiques et tels que précédemment définis et représentent notamment un hydrogène, les groupements R₅₁ et R₅₂ pouvant être identiques ou différents et les groupements R₅₃ et R₅₄ pouvant être identiques ou différents.

Dans une 1^{ère} forme de mise en oeuvre de ces motifs (XI) avantageux, les groupements R₅₁ et R₅₂ sont identiques et tels que précédemment définis et notamment représentent un hydrogène, les groupements R₅₃ et R₅₄ pouvant être identiques ou différents. Dans cette 1^{ère} forme de mise en oeuvre, les groupements R₅₃ et R₅₄ sont identiques et tels que précédemment définis et notamment représentent un hydrogène. En variante, les groupements R₅₃ et R₅₄ sont différents avec le groupement R₅₃ (ou R₅₄) représente un hydrogène et le groupement R₅₄ (ou R₅₃) représente un groupement alkyle éventuellement substitué ou un groupement aryle éventuellement substitué.

Dans une 2^{nde} forme de mise en oeuvre de ces motifs (XI) avantageux, les groupements R₅₁ et R₅₂ sont différents avec le groupement R₅₁ (ou R₅₂) représente un hydrogène et le groupement R₅₂ (ou R₅₁) représente un groupement alkyle éventuellement substitué ou un groupement aryle éventuellement substitué, les groupements R₅₃ et R₅₄ pouvant être identiques ou différents. Dans cette 2^{nde} forme de mise en oeuvre, les groupements R₅₃ et R₅₄ sont identiques et tels que précédemment définis et notamment représentent un hydrogène. En variante, les groupements R₅₃ et R₅₄ sont différents avec le groupement R₅₃ (ou R₅₄) représente un hydrogène et le groupement R₅₄ (ou R₅₃) représente un groupement alkyle éventuellement substitué ou un groupement aryle éventuellement substitué.

Parmi les motifs (XII), des motifs avantageux sont ceux dans lesquels les groupements R₅₇ à R₆₀ sont identiques et tels que précédemment définis et représentent notamment un hydrogène, les groupements R₆₁ et R₆₂ pouvant être identiques ou différents et les groupements R₆₃ et R₆₄ pouvant être identiques ou différents.

Dans une 1^{ère} forme de mise en oeuvre de ces motifs (XII) avantageux, les groupements R₆₁ et R₆₂ sont identiques et tels que précédemment définis et notamment représentent un hydrogène, les groupements R₆₃ et R₆₄ pouvant être identiques ou différents. Dans cette 1^{ère} forme de mise en oeuvre, les groupements R₆₃ et R₆₄ sont identiques et tels que précédemment définis et notamment représentent un hydrogène. En variante, les groupements R₆₃ et R₆₄ sont différents avec le groupement R₆₃ (ou R₆₄) représente un hydrogène et le groupement R₆₄ (ou R₆₃) représente un groupement alkyle éventuellement substitué ou un groupement aryle éventuellement substitué.

Dans une 2^{nde} forme de mise en oeuvre de ces motifs (XII) avantageux, les groupements R₆₁ et R₆₂ sont différents avec le groupement R₆₁ (ou R₆₂) représente un hydrogène et le groupement R₆₂ (ou R₆₁) représente un groupement alkyle éventuellement substitué ou un groupement aryle éventuellement substitué, les groupements R₆₃ et R₆₄ pouvant être identiques ou différents. Dans cette 2^{nde} forme de mise en oeuvre, les groupements R₆₃ et R₆₄ sont identiques et tels que précédemment définis et notamment représentent un hydrogène. En variante, les groupements R₆₃ et R₆₄ sont différents avec le groupement R₆₃ (ou R₆₄) représente un hydrogène et le groupement R₆₄ (ou R₆₃) représente un groupement alkyle éventuellement substitué ou un groupement aryle éventuellement substitué.

La présente description fournit un chromophore pi-conjugué pouvant comprendre au moins deux cycles aromatiques dont au moins un est un cycle de type sélénophène ou furanne.

Par « cycle sélénophène », on entend un cycle aromatique présentant un atome de sélénium et quatre atomes de carbone parmi lesquels deux peuvent éventuellement être substitués par des groupements, identiques ou différents.

Par « cycle furanne », on entend un cycle aromatique présentant un atome d'oxygène et quatre atomes de carbone parmi lesquels deux peuvent éventuellement être substitués par des groupements, identiques ou différents. A noter qu'un cycle furanone et qu'un cycle benzofuranone sont différents d'un cycle furanne et que, par conséquent, les colorants selon l'invention ne comprennent ni cycle furanone, ni cycle benzofuranone.

A titre de groupement(s) pouvant substituer le cycle sélénophène ou furanne, on peut citer les groupements précédemment listés dans le cadre des groupements alkyle, aryle et hydrocarboné substitués.

Ainsi, un tel chromophore pi-conjugué peut comprendre :
(i) un cycle furanne, au moins un groupement arylène éventuellement substitué et éventuellement au moins un groupement thiophène éventuellement substitué ;
(ii) un cycle sélénophène, au moins un groupement arylène éventuellement substitué et éventuellement au moins un groupement thiophène éventuellement substitué ;
(iii) au moins deux cycles furanne, éventuellement au moins un groupement arylène éventuellement substitué et éventuellement au moins un groupement thiophène éventuellement substitué ;
(iv) au moins deux cycles sélénophène, éventuellement au moins un groupement arylène éventuellement substitué et éventuellement au moins un groupement thiophène éventuellement substitué ;
(v) un cycle furanne, un cycle sélénophène, éventuellement au moins un groupement arylène éventuellement substitué et éventuellement au moins un groupement thiophène éventuellement substitué ;
(vi) au moins deux cycles sélénophène, un cycle furanne, éventuellement au moins un groupement arylène éventuellement substitué et éventuellement au moins un groupement thiophène éventuellement substitué ;
(vii) au moins deux cycles furanne, un cycle sélénophène, éventuellement au moins un groupement arylène éventuellement substitué et éventuellement au moins un groupement thiophène éventuellement substitué ;
(viii) au moins deux cycles sélénophène, au moins deux cycles furanne, éventuellement au moins un groupement arylène éventuellement substitué et éventuellement au moins un groupement thiophène éventuellement substitué.

Dans ces différentes formes de mise en oeuvre envisagées, tout ou partie des cycles peuvent être fusionnés ensemble et/ou tout ou partie des cycles sont séparés par une liaison covalente, par une chaîne alkylène éventuellement substituée, par une chaîne alcénylène ou alcynylène éventuellement substituée ou par une chaîne arylène éventuellement substituée telle que définie ci-après.

Certains des motifs envisagés pour les chromophores pi-conjugués comprenant au moins un cycle thiophène comprennent également un cycle furanne et/ou un cycle sélénophène (motifs V, VII, VIII ne faisant pas partie de l'invention, et motifs X et XI faisant partie de l'invention).

Le colorant organique selon la présente invention comprend au moins un chromophore pi-conjugué tel que défini dans la présente invention. Il peut en comprendre au moins deux, identiques ou différents ou au moins trois, identiques ou différents. Lorsque le colorant organique selon la présente invention comprend 2, 3 ou plus chromophores pi-conjugués, au moins un de ces chromophores est tel que défini dans la présente invention, chacun des autres pouvant être un quelconque chromophore pi-conjugué connu de l'homme du métier ou, au contraire, un chromophore tel que défini dans la présente invention.

Dans le colorant organique selon la présente invention, le chromophore pi-conjugué peut n'être constitué que par un motif ou plusieurs motifs, identiques ou différents, tels que précédemment exposés.

En variante, le chromophore pi-conjugué peut comprendre, en plus d'un motif ou de plusieurs motifs, identiques ou différents, tels que précédemment exposés, une 1^{ère} chaîne hydrocarbonée le ou les séparant du segment électro-donneur (eD) et/ou une 2^{nde} chaîne hydrocarbonée, identique ou différente à la 1^{ère}, le ou les séparant du segment électro-attracteur (A) ou du segment espaceur (L).

Les chaînes hydrocarbonées utilisables dans cette variante sont des groupements hydrocarbonés éventuellement substitués tels que précédemment définis et sont avantageusement choisies parmi les chaînes alkylène éventuellement substituées, les chaînes alcénylène ou alcynylène éventuellement substituées ou les chaînes arylène éventuellement substituées.

Dans le cadre de la présente invention, on entend par « chaîne alkylène » une chaîne alkylène linéaire, ramifiée ou cyclique, comprenant de 1 à 40 atomes de carbone, notamment de 2 à 30 atomes de carbone et pouvant comporter éventuellement au moins un hétéroatome. A titre d'exemples de chaînes alkylène utilisables, on peut citer les groupes méthylène, éthylène, n-propylène, isopropylène, butylène, isobutylène, *sec-*butylène, *tert*-butylène, pentylène, isopentylène, hexylène, cyclopentylène, cyclohexylène, -(CH₂)ₙ-O-(CH₂)ₘ-, -(CH₂)ₙ-S-(CH₂)ₘ-, -(CH₂)ₙ-S-S-(CH₂)ₘ-, -(CH₂)ₙ-C(O)O-(CH₂)ₘ-, -(CH₂)ₙ-N(R)-(CH₂)ₘ-, -(CH₂)ₙ-N(R')-(CH₂)ₚ-N(R")-(CH₂)ₘ- avec R représentant un groupement hydrocarboné tel que précédemment défini et n, m et p, identiques ou différents, représentant un nombre entier compris entre 0 et 20 ;

Dans le cadre de la présente invention, on entend par « chaîne alcénylène ou alcynylène », une chaîne alcénylène ou alcynylène, linéaire, ramifié ou cyclique, comprenant de 4 à 40 atomes de carbone et notamment de 4 à 30 atomes de carbone et pouvant comporter éventuellement au moins un hétéroatome. A titre d'exemples de chaînes alcénylène ou alcynylène utilisables, on peut citer un groupe buténylène ou butynylène, isobuténylène ou isobutynylène, *sec*-buténylène ou *sec*-butynylène, *tert-*buténylène ou *tert*-butynylène, penténylène ou pentynylène, isopenténylène ou isopentynylène, cyclopenténylène ou cyclopentynylène, cyclohexénylène ou cyclohexynylène.

Dans le cadre de la présente invention, on entend par « chaîne arylène », une chaîne arylène à un cycle ou plusieurs cycles fusionnés ou reliés par une liaison unique ou par un groupe hydrocarboné, chaque cycle ayant de 4 à 50 atomes de carbone et notamment de 4 à 40 atomes de carbone et pouvant comporter éventuellement au moins un hétéroatome. A titre d'exemples de chaînes arylène utilisables, on peut citer les groupes phénylène, biphénylène, naphtylène, anthracénylène, cyclopentadiénylène, pyrénylène, tétrahydronaphtylène, furanylène, pyrrolylène, thiophénylène, oxazolylène, pyrazolylène, isoquinolinylène, thiazolylène, imidazolylène, triazolylène, pyridinylène, pyranylène, quinolinylène, pyrazinylène et pyrimidinylène.

Dans le cadre de la présente invention, on entend par « chaîne alkylène substituée », par « chaîne alcénylène ou alcynylène substituée » ou par « chaîne arylène substituée » une chaîne alkylène, une chaîne alcénylène ou alcynylène ou une chaîne arylène telle que précédemment définie présentant une substitution ou plusieurs substitutions, identiques ou différentes, cette ou ces substitutions correspondant, de préférence, à des atomes d'halogène ou à des groupes aliphatiques comprenant éventuellement au moins un hétéroatome comme, par exemple, un groupe -COOR", -CHO, -OR", -SR", -SCOR", -SO₂R", -NR"R''', -CONR"R''', -C(Hal)₃, -OC(Hal)₃, -C(O)Hal ou -CN dans lesquels R" et R''' représentent un atome d'hydrogène ou un groupement hydrocarboné tel que précédemment défini, tandis que Hal représente un atome d'halogène, notamment de fluor, de chlore ou de brome.

Par « segment électro-donneur (eD) » on entend, dans le cadre de la présente invention, une fonction électro-donneur qui permet au colorant organique selon la présente invention d'être réduit plus facilement par l'électrolyte.

L'homme du métier connaît des segments électro-donneurs habituellement utilisés dans le domaine des colorants organiques photosensibilisateurs. A titre d'exemples de tels segments électro-donneurs, on peut citer ceux décrits de la page 42, ligne 10 à la page 45, ligne 1 de la demande internationale WO 2009/109499 **[7]** et ceux mis en oeuvre dans les 56 colorants organiques décrits dans Mishra et al., 2009 **[3].**

Le segment électro-donneur mis en oeuvre dans le cadre de la présente invention est un groupement amino de type (Z₁)(Z₂)N-, avec Z₁ et Z₂, identiques ou différents, représentant un groupement alkyle éventuellement substitué ou un groupement aryle éventuellement substitué tel que précédemment défini. En particulier, lorsque Z₁ et/ou Z₂, identiques ou différents, représentent un groupement aryle substitué, ce dernier est substitué par un groupement ou plusieurs groupements, identiques ou différents, à caractère électro-donneur. Par « groupement à caractère électro-donneur », on entend, dans le cadre de la présente invention, un groupement choisi parmi un groupement alkyle, comprenant de 1 à 10 atomes de carbone, éventuellement substitué ; un groupement alcoxy comprenant de 1 à 10 atomes de carbone, éventuellement substitué ; un groupement diamine et notamment un groupement di(alkyl)amino éventuellement substitué sur le (ou les) groupement(s) alkyle par un hydroxy; un groupement alkylthio et un groupement thioéther.

Dans la partie expérimentale ci-après, deux exemples de segment électro-donneur sont donnés, ces derniers étant utilisables dans tout colorant organique selon l'invention.

Par « segment électro-accepteur (A) » on entend, dans le cadre de la présente invention, une fonction électro-accepteur qui assure l'ancrage du colorant organique selon la présente invention sur le support solide tel qu'un support solide de type oxyde métallique tout en assurant un bon transfert de charges entre ledit support et ledit colorant.

L'homme du métier connaît des segments électro-accepteurs habituellement utilisés dans le domaine des colorants organiques photosensibilisateurs. A titre d'exemples de tels segments électro-accepteurs, on peut citer ceux tels que définis page 1, lignes 26 et 27 et notamment exemplifiés page 29, lignes 7 à 23 ; page 37, lignes 6 à 9 ; de la page 46, ligne 6 à la page 47, ligne 1 ou de la page 47, lignes 2 à 8 de la demande internationale WO 2009/109499 **[7]** et ceux mis en oeuvre dans les 56 colorants organiques décrits dans Mishra et al., 2009 **[3].**

Le segment électro-accepteur mis en oeuvre dans le cadre de la présente invention est un groupement acide carboxylique, un groupement acide cyanoacrylique, un groupement phosphonique, un groupement dithiocarboïque ou un groupement répondant à l'une quelconque des formules ci-après :

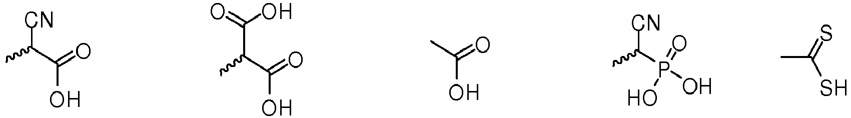

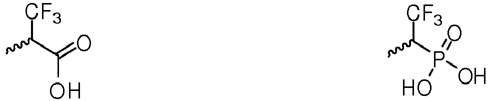

Dans le cadre de la présente invention, le chromophore pi-conjugué et le segment électro-accepteur sont avantageusement séparés l'un de l'autre par un espaceur (L).

L'homme du métier connaît des espaceurs habituellement utilisés dans le domaine des colorants organiques photosensibilisateurs. A titre d'exemples de tels espaceurs, on peut citer ceux mis en oeuvre dans les 56 colorants organiques décrits dans Mishra et al., 2009 **[3]**.

Dans le cadre de la présente invention, l'espaceur L est une fonction pi-conjuguée comme une chaîne alcénylène ou alcynylène éventuellement substituée ou une chaîne arylène éventuellement substituée telle que précédemment définie. A titre d'espaceurs plus particuliers susceptibles d'être mis en oeuvre dans le cadre de la présente invention, on peut citer une chaîne éthylényle, propylényle, butényle, phénylène, benzylène ou naphtylène.

De façon avantageuse, lorsque l'espaceur L mis en oeuvre dans le cadre de la présente invention comprend une double liaison, cette dernière est séparée du 1^{er} cycle thiophène que peut contenir le chromophore pi-conjugué à proximité de l'espaceur par au moins une chaîne arylène éventuellement substituée telle que précédemment définie et notamment par au moins un phénylène éventuellement substitué. Il convient de noter que ce phénylène peut être un phénylène déjà présent dans certains des motifs X à XII précédemment décrits. En d'autres termes, lorsque l'espaceur L comprend une double liaison, le colorant organique présente un phénylène appartenant soit à cet espaceur L, soit à un motif choisi entre les motifs X à XII.

De façon particulièrement avantageuse, le colorant organique est choisi parmi les composés suivants : 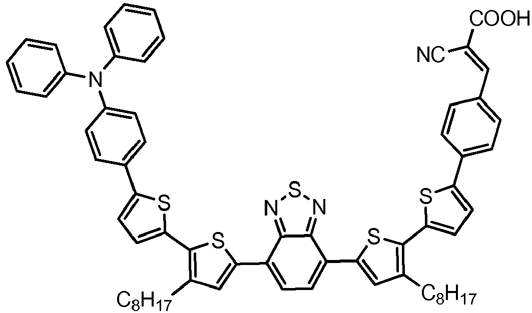 faisant partie de l'invention 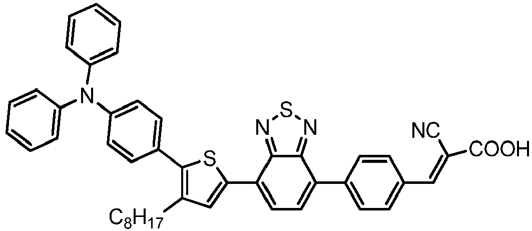 faisant partie de l'invention 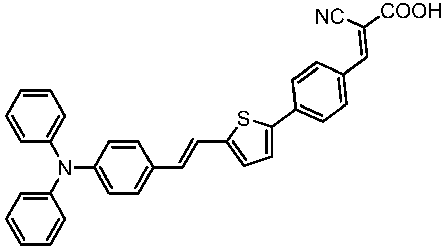 ne faisant pas partie de l'invention 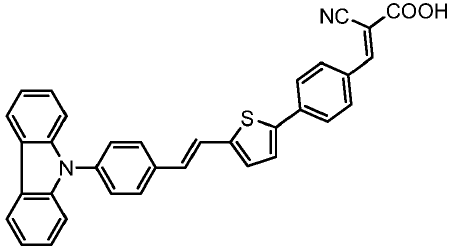 ne faisant pas partie de l'invention 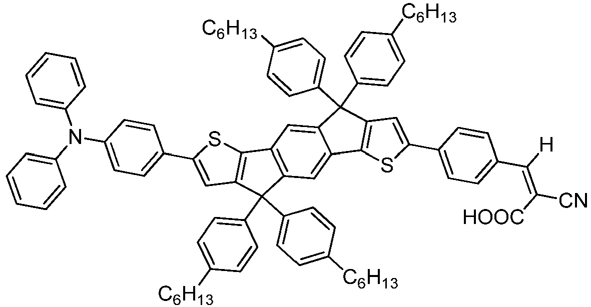 ne faisant pas partie de l'invention 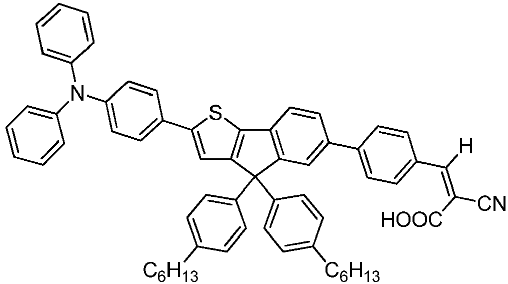 ne faisant pas partie de l'invention 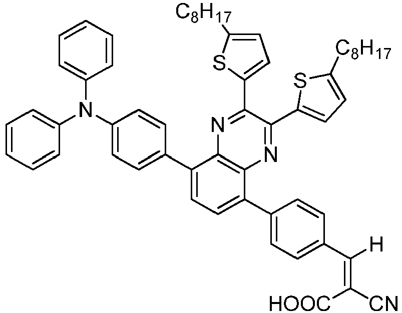 ne faisant pas partie de l'invention 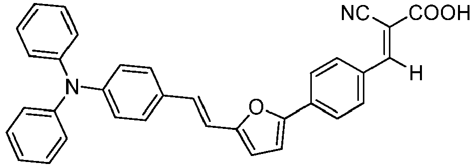 ne faisant pas partie de l'invention 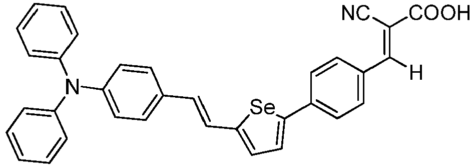 ne faisant pas partie de l'invention 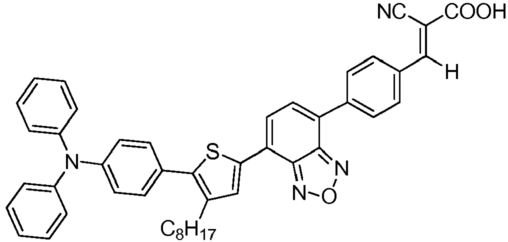 faisant partie de l'invention 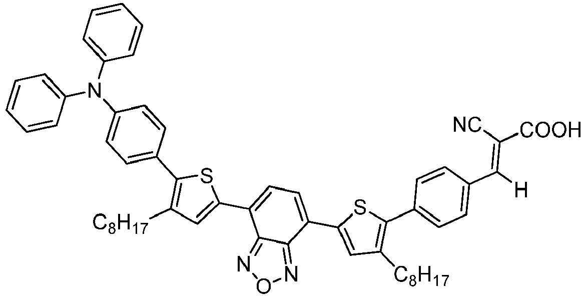 faisant partie de l'invention 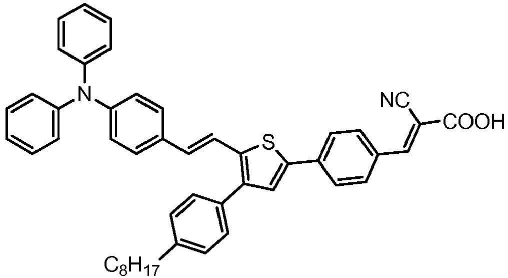 ne faisant pas partie de l'invention 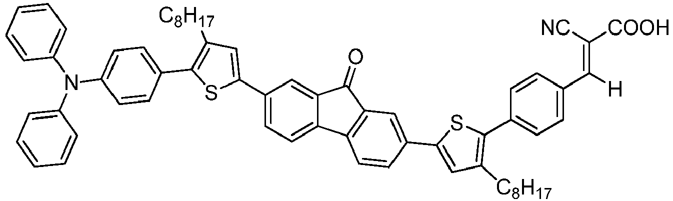 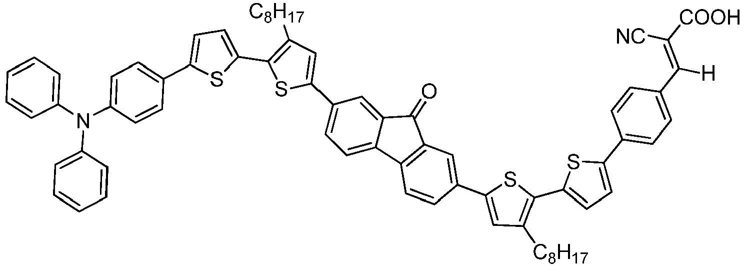 les deux composés ci-dessus ne faisant pas partie de l'invention 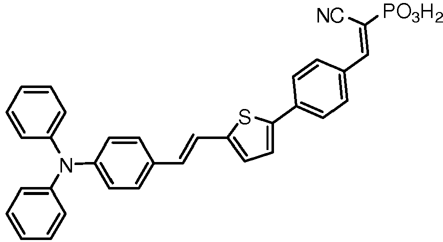 ne faisant pas partie de l'invention 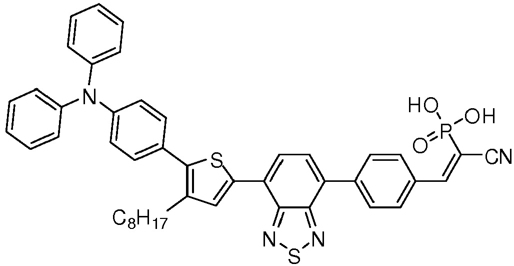 faisant partie de l'invention 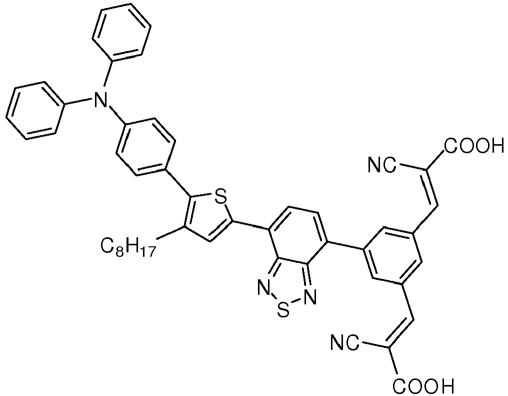 faisant partie de l'invention

Pour tous les motifs et structures décrits dans la présente invention, cette dernière couvre l'ensemble des stéréo-isomères, l'ensemble des tautomères et l'ensemble des énantiomères envisageables.

La présente invention concerne également un procédé de préparation d'un colorant organique tel que défini dans la présente invention. Ce procédé de préparation met en oeuvre des réactions chimiques bien connues de l'homme du métier. Ce dernier, sur la base des différents protocoles explicités dans la partie expérimentale ci-après et des protocoles de préparation des colorants organiques de l'état de la technique, pourra préparer tout colorant organique selon la présente invention sans aucun effort inventif.

La présente invention concerne en outre un colorant organique tel que précédemment défini utilisé comme photosensibilisateur dans un dispositif photovoltaïque.

Dans le cadre de la présente invention, les expressions « dispositif photovoltaïque » et « cellule photovoltaïque » sont similaires et utilisables de façon interchangeable.

De fait, la présente invention concerne le dispositif photovoltaïque ainsi obtenu i.e. un dispositif photovoltaïque présentant une couche d'oxyde métallique semi-conducteur nanostructuré sensibilisée par un colorant organique tel que défini dans la présente invention.

En d'autres termes, le colorant organique tel précédemment défini a réagi avec la couche d'oxyde métallique via son segment électro-attracteur pour donner un groupement dérivé du colorant organique fonctionnalisant, i.e. covalemment lié à, la couche d'oxyde métallique. Ces groupements fonctionnalisants présentent donc un segment électro-donneur (eD), un chromophore pi-conjugué, éventuellement un espaceur (L) et un groupement dérivé du segment électro-accepteur (A) covalemment lié à la couche d'oxyde métallique, le segment électro-donneur (eD), le chromophore pi-conjugué, l'espaceur (L) et le segment électro-accepteur (A) étant tels que précédemment définis.

Dans le cadre de la présente invention, lorsque le colorant organique réagit avec, i.e. est adsorbé sur, la couche d'oxyde métallique, cette réaction peut avoir lieu en présence d'un additif tel qu'un autre colorant organique ou un co-adsorbant.

L'autre colorant organique qui peut être également adsorbé sur la couche d'oxyde métallique peut être (a) un autre colorant selon la présente invention, (b) un mélange de colorants selon la présente invention, (c) un autre colorant différent d'un colorant selon la présente invention et (d) un mélange comprenant au moins un autre colorant selon la présente invention et au moins un autre colorant différent d'un colorant selon la présente invention.

Par « colorant différent d'un colorant selon la présente invention », on entend, dans le cadre la présente invention, un colorant choisi parmi un colorant complexe métallique et/ou un colorant organique tel qu'un colorant de type indoline, courmarine, cyanine, merocyanine, hemicyanine, methine, azo, quinone, quinonimine, dicéto-pyrrolo-pyrrole, quinacridone, squaraine, triphénylméthane, pérylène, indigo, xanthène, éosin, rhodamine, phtalocyanine éventuellement métallée, porphyrine éventuellement métallée et leurs mélanges.

A titre de co-adsorbants utilisables dans le cadre de la présente invention, on peut citer les co-adsorbants stéroïdes tels que l'acide déoxycholique, l'acide déhydrodéoxycholique, l'acide chénodéoxycholique, l'ester méthylique d'acide cholique, le sel sodique d'acide cholique ou un de leurs mélanges.

Le dispositif photovoltaïque selon la présente invention comprend en outre deux électrodes, dénommées, dans le cadre de l'invention, anode et contre électrode, et séparées l'une de l'autre par un électrolyte et éventuellement des cales polymères.

Avantageusement, l'anode mise en oeuvre dans le cadre de la présente invention est constituée d'une couche de dioxyde d'étain dopé au fluor (SnO₂:F ou FTO) ou d'oxyde d'étain et d'indium (ITO) déposée sur une plaque de verre.

Dans le cadre de la présente invention, on entend par « oxyde métallique semi-conducteur » tout oxyde métallique binaire, tertiaire ou quaternaire. Dans le cadre de la présente invention, on entend par « oxyde métallique semi-conducteur nanostructuré » tout oxyde métallique semi-conducteur tel que précédemment défini comprenant des pores et notamment des pores dont la taille moyenne est comprise entre 20 et 500 Å i.e. tout oxyde métallique semi-conducteur tel que précédemment défini mésoporeux. Ainsi, la couche d'oxyde métallique semi-conducteur nanostructuré sous forme d'une couche mésoporeuse est déposée sur l'anode telle que précédemment définie.

Dans le cadre de la présente invention, on entend, par « oxyde métallique binaire », un oxyde métallique de type M^{II}O, M^{III}₂O₃ ou M^{V}₂O₅ avec M représentant un métal mono-, bi -, tri-, pentavalent et O l'atome d'oxygène. A titre d'exemples de tels oxydes métalliques binaires, on peut citer TiO₂, ZnO, SnO₂, Nb₂O₅, In₂O₃ et RuO₂.

Dans le cadre de la présente invention, on entend, par « oxyde métallique tertiaire », un oxyde métallique multications de type MM'O avec M et M' représentant deux métaux bivalents différents. A titre indicatif, on peut citer Zn_{z}SnO₄, SrTiO₄, SrTiO₃, BaSnO₃.

Dans le cadre de la présente invention, on entend, par « oxyde métallique quaternaire », une composition d'oxydes mixtes. Dans le cadre de la présente invention, on entend, par « composition d'oxydes mixtes » :
- un mélange de deux oxydes binaires tels que précédemment définis. On peut citer par exemple des mélanges tels que (ZnO)₁₋ₓ-(SnO₂)ₓ, (TiO₂)₁₋ₓ-(Nb₂O₅)ₓ, ou
- un mélange d'un oxyde binaire et d'un oxyde tertiaire tels que précédemment définis. On peut citer par exemple un mélange de (SnO₂)-(SrTiO₃).

Dans le cadre du dispositif photovoltaïque selon la présente invention, l'électrolyte peut être un liquide, un liquide ionique, un gel ou un solide. Un tel électrolyte est notamment tel que présenté dans le livre de Kalyanasundaram K., 2010 [16].

Lorsque l'électrolyte est un électrolyte liquide, il est avantageusement choisi parmi les électrolytes liquides habituels tels que I⁻/I₃⁻, Br⁻/Br₂, SCN⁻/(SCN)₂ ou des complexes de cobalt de type Co(III/II).

Lorsque l'électrolyte est un électrolyte de type gel ou liquide ionique, il est avantageusement choisi parmi les sels d'imidazolium tels que, à titre d'exemples et de manière non exhaustive, le sélénocyanate de 1-éthyl-3-méthylimidazolium (EMISeCN), le thiocyanate de 1-éthyl-3-méthylimidazolium (EMISCN) ou l'iodure de 1-méthyl-3-n-hexylimidazolium (MHIml).

Lorsque l'électrolyte est un électrolyte de type solide, il est avantageusement choisi parmi un solide semi-conducteur de type p, tel qu'un polymère ou une petite molécule, pouvant être déposé par voie liquide. Plus particulièrement, l'électrolyte de type solide susceptible d'être mis en oeuvre dans le cadre de la présente invention est choisi parmi le composé spiro-OMeTAD ou un dérivé de triarylamine. On peut utiliser également un polymère pi-conjugué comme, par exemple, du poly(3,4-éthylènedioxythiophène) (PEDOT) ou un mélange de PEDOT et de poly(styrène sulfonate) de sodium (PSS) connu sous l'appellation PEDOT:PSS.) On peut également utiliser un polymère de type poly(oxyde d'éthylène) contenant un couple rédox ou encore la polyaniline.

Quel que soit le type d'électrolyte mis en oeuvre dans le cadre de la présente invention, ce dernier comprend en outre un couple redox tel que le couple redox I⁻/I³⁻ ou un complexe de cobalt et éventuellement un anion du type bis(trifluoro-méthanesulfonyl)imide (TFSI) tel que du Li-TFSI et ce pour améliorer la conductivité de l'électrolyte.

Dans le cadre de la présente invention, on entend, par « cale polymère », un polymère adhésif thermique permettant de sertir les deux électrodes. De tels polymères adhésifs sont notamment les colles de chez Solaronix telles que celles de la gamme Amosil ou encore Meltonix ou encore les colles de la gamme FastelFilm de chez Dupond Ces polymères se présentent sous la forme de feuilles thermoplastiques épaisses thermofusibles. L'étanchéité survient lorsque le polymère est chauffé à environ 100°C pendant quelques secondes, par exemple, à l'aide d'un laminateur à vide, d'une presse à chaud ou d'un fer à souder pour les petites surfaces. Typiquement, les joints ou les bandes sont découpé(e)s et disposé(e)s sur le substrat d'électrode avant une lamination à chaud.

Enfin, la contre-électrode du dispositif photovoltaïque selon la présente invention est constituée par une couche métallique déposée sur un support solide transparent de FTO selon un mode opératoire bien connu de l'homme de métier.

D'autres caractéristiques et avantages de la présente invention apparaîtront encore à l'homme du métier à la lecture des exemples ci-dessous donnés à titre illustratif et non limitatif, et faisant référence aux figures annexées.

### BRÈVE DESCRIPTION DES DESSINS

La Figure 1 est une représentation schématisée d'une cellule photovoltaïque telle que décrite dans l'article de O'Regan et Grätzel, 1991 **[1].**
La Figure 2 présente le spectre d'absorption d'un colorant organique ne faisant pas partie de la présente invention (YKP29) comparé au spectre d'absorption d'un colorant organique témoin (YKP28).
La Figure 3 présente la densité de courant délivré par des cellules photovoltaïques comprenant un colorant organique ne faisant pas partie la présente invention (YKP29) ou des colorants organiques témoins (YKP28 et D102).
La Figure 4 présente la densité de courant délivré par des cellules photovoltaïques comprenant des colorants organiques selon la présente invention (GB043 et GB062) ou un colorant organique témoin (D102).

### EXPOSÉ DÉTAILLÉ DE MODES DE RÉALISATION PARTICULIERS

### I. Synthèse des colorants YKP29 et YKP61 (ne faisant pas partie de l'invention).

### I.1. N,N-diphenyl-4-vinylaniline [YKP21]

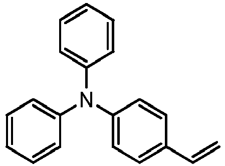

Dans un bicol, sous atmosphère d'argon, 22,18 g (54,87 mmol) d'iodure de méthyl(triphényl)phosphonium sont dissous dans 100 mL de tétrahydrofurane (THF) fraîchement distillé. Après que le mélange est amené à la température de 0°C, on incorpore 1,5 eq (6,16 g) de tert-butoxyde de potassium. Après 30 min d'agitation à 0°C, on ajoute au mélange, goutte à goutte, une solution de 4-(N,N-diphénylamino)-benzaldéhyde (10 g, 36,80 mmol) dans 30 mL de THF. On laisse ensuite la température du milieu remonter à température ambiante et l'agitation se poursuit 4 h supplémentaires. Le milieu est ensuite hydrolysé par une solution de carbonate de sodium saturée puis extrait au dichlorométhane. La phase organique est lavée successivement par de l'eau, une solution saturée de NaCl puis séchée sur Na₂SO₄. Après filtration et évaporation, le produit brut est purifié sur colonne de chromatographie sur silice [éluant-hexane/éther éthylique : 80/20].

On obtient 5,82 g du composé YKP21 sous forme de solide blanc cassé (rendement de 58,5%).

| | |
|---|---|
| *RMN ¹H (CDCl₃):* | *5,20 (dd, 1H, J=10,8 Hz, J=1,2 Hz) ; 5,68 (dd, 1H, J=17,5 Hz, J=1,2 Hz) ; 6,71 (dd, 1H, J=17,5 Hz, J=10,8 Hz) ; 7,10 (m, 8H) ; 7,30 (m, 6H)* |
| *RMN ¹³C(CDCl₃):* | *147,4; 136,0; 131,7 ; 129,1 ; 126,9 ; 124,2 ; 123,4 ; 122,7* |

### I.2. 4-(5-bromothiophèn-2-yl) benzaldéhyde [YKP24].

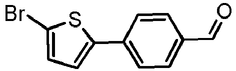

Dans un bicol sous argon, 0,75 g (3,98 mmol) de 4-(2-thiényl)benzaldéhyde dans 20 mL de diméthylformamide (DMF) sont refroidis à 0°C. 1,1 éq (0,78 g, 4,38 mmol) de N-bromosuccinimide (NBS) est solubilisé dans un mélange de 10 mL de DMF et de 10 mL de méthanol. Cette solution de NBS (protégée de la lumière) est ensuite additionnée goutte à goutte (30 min) sur le milieu réactionnel. On laisse ensuite la température du milieu remonter à température ambiante en 2 h. Le milieu est hydrolysé par une solution d'HCl 1 mol.L⁻¹ et extrait à l'éther éthylique. Les phases organiques rassemblées sont lavées par une solution saturée de NaCl puis séchées sur du Na₂SO₄ anhydre. Après filtration et évaporation à sec, le mélange réactionnel est recristallisé par de l'acétone. On obtient 0,75 g du composé YKP24 sous forme de solide blanc (rendement de 70,6%).

| | |
|---|---|
| *RMN ¹H (CDCl₃):* | *7,10 (dd, 1H, J=4,0 Hz, J=0,5 Hz), 7,20 (dd, 1H, J=3,9 Hz, J=0,5 Hz), 7,66 (d, 2H, J=8,27 Hz), 7,88 (d, 2H, J=8,19 Hz), 10,00 (s, 1H)* |

### I.3. 4-(5-(4-(diphénylamino)styryl)thiophèn-2-yl)benzaldéhyde [YKP25].

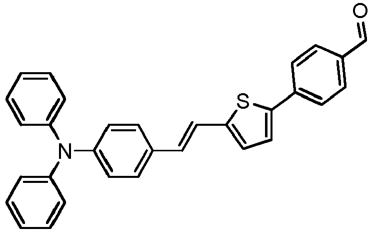

Dans un tricol sous argon, on introduit, dans l'ordre successif, 0,75 g (2,81 mmol) de YKP24, 27 mg (1%) du catalyseur trans-di(µ-acétato)bis[o-(di-o-tolylphosphino)benzyl] dipalladium(II), 124 mg (20%) de 2,6-di-tert-butylcresol et 655 mg (2,2 eq) de carbonate de sodium. Le tout après dissolution dans 15 mL de N,N-diméthylacétamide (DMAC) préalablement dégazé est porté à 90°C. Une solution de 15 mL de DMAC contenant 1,52 g (2 eq) de YKP21 est ajoutée goutte à goutte à notre mélange. Après l'ajout, le tout est porté à 135°C et agité pendant 24h. Le lendemain après refroidissement, le contenu du tricol est ajouté à 200 mL de mélange de [CH₂Cl₂ /eau : 50/50]. La phase organique est lavée successivement par une solution d'HCl à 2 mol.L⁻¹, par de l'eau, par une solution saturée de NaCl puis séchée sur Na₂SO₄. Après filtration et évaporation, le produit brut est purifié sur colonne de chromatographie sur silice [éluant - hexane/acétate d'éthyle : 95/05]. On obtient après cette réaction de Heck, 0,52 g du composé YKP25 sous forme d'un solide orange (rendement de 40,5%).

| | |
|---|---|
| *RMN ¹H (CDCl₃):* | *7,08 (m, 10H), 7,35 (m, 6H), 7,52 (d, 1H, J=8,58 Hz), 7,72 (d, 1H, J=3,81 Hz), 7,92(q, 4H), 10,00 (s, 1H)* |

### I.4. Acide 2-cyano-3-(4-(5-(4(diphenylamino)styryl)thiophen-2-yl)phenyl)acrylique [YKP29].

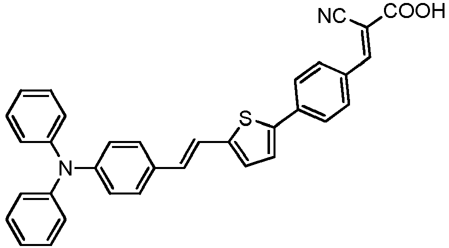

Le composé YKP29 est obtenu suite à une condensation de Knoevenagel. On introduit de ce fait, dans un bicol contenant 30 mL de CH₃CN sous atmosphère d'argon, 395 mg (0,863 mmol) de YKP25, 1,47 g (20 eq) de cyanoacide acétique, quelques gouttes catalytiques de pyridine. Le tout est porté à reflux pendant 2 h. On évapore l'acétonitrile au rotavapeur et on reprend l'ensemble par du chloroforme. La phase organique est lavée successivement par une solution d'HCl 2 mol.L-1, par de l'eau, puis séchée sur du Na₂SO₄. Le produit désiré précipite dans l'hexane. Après filtration et séchage à l'étuve, on obtient 305 mg du composé YKP29 sous forme de solide foncé (rendement de 69,6%).

| | |
|---|---|
| *RMN ¹H (DMSO):* | *7,10 (m, 9H), 7,35 (m, 6H), 7,52 (d, 2H, J=8,68 Hz), 7,74 (d, 1H, J=3,84 Hz), 7,91(d, 2H, J=8,48 Hz), 8,10(d, 2H, J=8,66 Hz), 13,98 (s, 1H)* |

### I.5. Diéthyl (1-cyano2-(4-(5-(4-diphénylaminostyryl)thiophen-2-yl)phényl) vinyl)phosphate [YKP57].

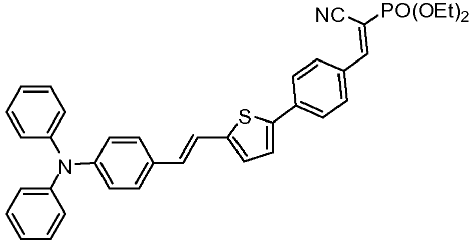

Une autre condensation de Knoevenagel est réalisée en introduisant dans un bicol contenant 15 mL de CH₃CN sous atmosphère d'argon, 280 mg (0,612 mmol) de YKP25, 1,47 g (1,2 eq) de diéthylcyanométhylphosphonate, quelques gouttes catalytiques de pyridine. Le tout est porté à reflux pendant 2 h. On évapore l'acétonitrile au rotavapor et on reprend l'ensemble par du chloroforme. La phase organique est lavée par de l'eau, puis séchée sur Na₂SO₄. Après filtration et évaporation, le produit brut est purifié sur colonne de chromatographie sur silice [éluant : CHCl₃/acétate d'éthyle : 9/1] dont on obtient 253 mg du composé YKP57 (rendement de 66,9%).

| | |
|---|---|
| RMN ¹H (CDCl₃): | *8,05 (d, 1H, J=3,9 Hz), 7,98 (d, 2H, J=8,95Hz), 7,74 (d, 2H, J=8,49Hz), 7,42-7,28 (m, 7H), 7,17-7,01 (m, 9H), 4,28 (m 4H), 1,46 (td, 6H, J1=7,04 Hz, J2=0,64Hz)* |

### I.6. Acide (1-cyano2-(4-(5-(4-diphénylaminostyryl)thiophen-2-yl)phényl)vinyl) phosphonique [YKP61].

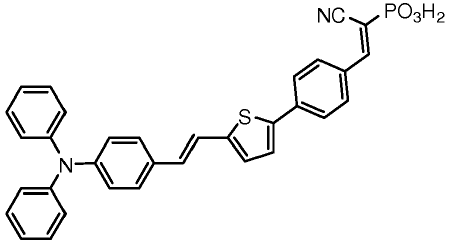

Dans un bicol, on place YKP57 dans 10mL de CH₂Cl₂ à reflux pendant 30 min et on ajoute par injection BrSi(Me)₃ en large excès et on laisse 1 h à reflux. On refroidit, on évapore le dichlorométhane et on sépare par chromatographie, THF-Méthanol (9-1) comme éluant. On obtient un solide orangé rouge.

### II. Synthèse du colorant YKP64 (ne faisant pas partie de l'invention).

### II.1. 4-(9H-carbazol-9-yl)bezaldehyde [YKP46].

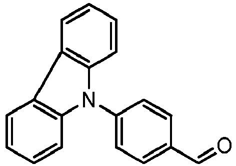

Dans un tricol sous argon, une solution contenant 8,4 g (0,05 mol) de carbazole et 5,5 g (1 eq) de tert-butoxyde de potassium (t-BuOK) dans 200 mL de DMF est chauffée à 110°C. Après 30 min de réaction, on incorpore la masse catalytique de palladium tris-(*tertio*-butyle) (Pd(t-Bu₃)₃) fraîchement synthétisé selon le protocole décrit ci-dessous. On ajoute ensuite 6 g (1 eq) de 4-fluorobenzaldéhyde goutte à goutte au mélange. Le tout est maintenu sous agitation à la température de 110°C pendant 36 h. Après retour à la température ambiante, le contenu du ballon est jeté dans 300 mL d'eau. Cette solution est filtrée et extraite par du CH₂Cl₂. Les phases organiques sont
rassemblées et lavées successivement par une solution d'HCl (2 mol.L⁻¹), par de l'eau, puis séchées sur du Na₂SO₄. Après filtration et évaporation, le produit brut est purifié sur colonne de chromatographie sur silice [éluant - cyclohexane/chloroforme : 6/4]. On obtient 10,07 g du composé YKP46 sous forme de solide blanc (rendement de 74,7%).

| | |
|---|---|
| *RMN ¹H (CDCl₃):* | *7,34 (td, 2H, J=7,5Hz, J=1,5Hz), 7,45 (td, 2H, J=7,1Hz, J=1,36Hz), 7,52 (td, 2H, J=8,12 Hz, J=0,9Hz), 7,82(dt, 2H, J=6,6 Hz, J=2,0Hz), 10,12 (s, 1H)* |

Le Catalyseur : Pd(t-Bu₃)₃

Le catalyseur est synthétisé par réaction de la tri(tert-butyl)phosphine sur l'acétate de palladium II (Pd(OAc)₂). Dans un bicol, on introduit 107 mg (0,48 mmol, 2%) de Pd(OAc)₂ et 2,4 mL (1,2 mmol, 5%) de tri(tert-butyl)phosphine. Sous argon, 10 mL de toluène anhydre sont ajoutés et le tout est porté à la température de 60°C pendant 30 min. On obtient alors notre catalyseur de couleur jaune poussin prêt à être injecté au milieu réactionnel.

### II.2. 9-(4-vinylphényl)-9H-carbazol [YKP48].

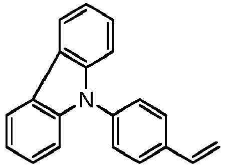

Dans un bicol sous atmosphère d'argon, 12,65 g (31,29 mmol) d'iodure de méthyl(triphényl)phosphonium sont dissous dans 50 mL de THF fraîchement distillé. Après que le mélange est amené à la température de 0°C, on incorpore 1,5 eq (3,51 g) de tert-butoxyde de potassium. Après 30 min d'agitation à 0°C, une solution de YKP46 (5,64 g, 20,86 mmol, 0,66 eq) dans 30 mL de THF est ajoutée goutte à goutte au mélange. On laisse ensuite la température du milieu remonter à température ambiante et l'agitation se poursuit 4 h supplémentaires. Le milieu est ensuite hydrolysé par une solution de carbonate de sodium saturé puis extrait au dichlorométhane. La phase organique est lavée successivement par de l'eau, une solution saturée de NaCl puis séchée sur du Na₂SO₄. Après filtration et évaporation, le produit brut est purifié sur colonne de chromatographie sur silice [éluant - cyclohexane/ chloroforme : 6/4]. On obtient 3,22 g du composé YKP48 sous forme de solide jaune clair (rendement de 57,5%).

| | |
|---|---|
| *RMN ¹H (CDCl₃):* | *5,41 (dd, 1H, J=11,5 Hz, J=0,7 Hz); 5,90 (dd, 1H, J=17,5 Hz, J=0,7 Hz); 6,88 (dd, 1H, J=17,5 Hz, J=11,8 Hz); 7,33 (m, 2H); 7,46 (dm, 4H); 7,58 (td, 2H, J =8,59 Hz, J=2,2Hz); 7,69(dt, 2H, J =8,6 Hz, J=2,0Hz); 8,19 (dt, 2H, J=7,8 Hz, J=1,0Hz)* |

### II.3. 4-(5-(4-(9H-carbazol-9-yl)styryl)thiophén-2-yl)benzaldéhyde [YKP63].

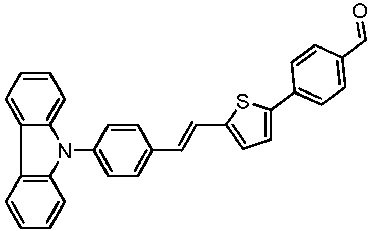

Dans un tricol sous argon, on introduit, dans l'ordre successif, 515 mg (1,85 mmol, 1 eq) de YKP51, 18 mg (1%) du catalyseur trans-di(µ-acétato)bis[o-(di-o-tolylphosphino)benzyl] dipalladium(II), 90 mg (20%) de 2,6-di-tert-butylcresol et 460 mg (2,2 eq) de carbonate de sodium. Le tout après dissolution dans 15 mL de DMAC préalablement dégazé est porté à 90°C. Une solution de 15 mL de DMAC contenant 1,00 g (2 eq) de YKP48 est ajoutée goutte à goutte au mélange. Après l'ajout, le mélange réactionnel rouge est porté à 135°C et agité pendant 24 h. Le lendemain après refroidissement, le contenu du tricol est ajouté à 200 mL d'un mélange de [CH₂Cl₂/eau : 50/50]. La phase organique est lavée successivement par une solution d'HCl 2 mol.L⁻¹, par de l'eau, par une solution saturée de NaCl puis séchée sur du Na₂SO₄. Après filtration et évaporation, le produit brut est purifié sur colonne de chromatographie sur silice [éluant - cyclohexane/acétate d'éthyle : 95/05]. On obtient, après cette réaction de Heck, 490 mg du composé YKP63 sous forme d'un solide orange (rendement de 58,2%).

| | |
|---|---|
| *RMN ¹H(CDCl₃):* | *7,18 (t, 3H), 7,35(m, 3H), 7,47 (m, 5H), 7,69 (dd, 4H, J=8,50 Hz), 7,89 (dd, 4H, J=8,54 Hz), 8,20 (dt, 2H, J=7,57 Hz, J=1,1 Hz), 10,05 (s, 1H)* |

### II.4. Acide 3-(4-(E)-4(9H-carbazol-9-yl)styryl) phenyl)-2-cyanoacrylique [YKP64].

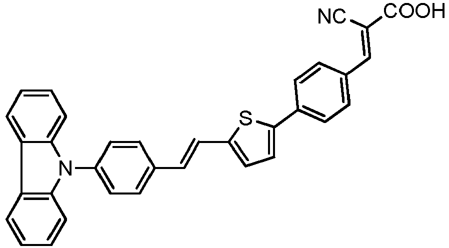

Le composé YKP64 est obtenu suite à une réaction de Knoevenagel. On introduit dans un bicol contenant 20 mL de CH₃CN sous atmosphère d'argon, 200 mg (0,44 mmol) de YKP63, 45 mg (1,2 eq) de cyanoacide acétique, quelques gouttes catalytiques de pyridine. Le tout est porté à reflux pendant 2 h. On évapore l'acétonitrile au rotavapeur et on reprend l'ensemble par du chloroforme. La phase organique est lavée successivement par une solution d'HCl 2 mol.L⁻¹, par de l'eau, puis séchée sur Na₂SO₄. Le produit désiré précipite dans un mélange d'hexane et d'éther de pétrole. Après filtration et séchage à l'étuve, on obtient 180 mg du composé YKP64 sous forme de solide foncé (rendement de 78,0%).

| | |
|---|---|
| *RMN ¹H (CDCl₃):* | *14,0(s, br 1H, (COOH)), 8,33 (s, 1H), 8,26 (d, 2H, J= 7.6Hz), 8,12 (d, 2H, J= 7,6Hz), 7,90 (d, 4H, J= 8,6Hz), 7,76 (d, 2H, J= 3,8Hz), 7,6(m, 2H), 7,16-7,75 (m, 8H)* |

### III. Synthèse des colorants GB043, YKP125 et YKP126 (faisant partie de l'invention).

### III.1. 2-triphénylamino-3-octylthiophène [GB008].

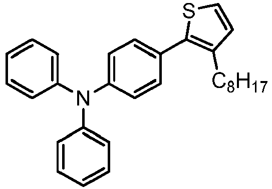

On introduit dans un bicol muni d'un réfrigérant et d'un septum, 1,65 g (4,63 mmol, 1,1 éq) de 4-(diphénylamino)phénylboronique et 1,16 g (4,21 mmol, 1 éq) de 2-bromo-3-octylthiophène en présence de 1,03 g (5,05 mmol, 2,3 éq) de K₃PO₄ et 200 mg (4% molaire) de Pd(PPh₃)₄ dans 30 mL de DMF. Le mélange est agité pendant 14 h à 75°C. Après un traitement du mélange avec 100 mL d'eau, la phase aqueuse est lavée par 2 × 100 mL d'éther. Les phases organiques sont lavées avec 2 × 100 mL de solution NaCl saturée et séchées sur Na₂SO₄. Après filtration et évaporation du solvant, la purification s'effectue sur colonne de silice avec un éluant [hexane/CH₂Cl₂ : 2/1]. On obtient 1,67 g de composé final sous forme d'une huile jaune (rendement de 86,0%).

| | |
|---|---|
| *RMN ¹H (CD₂Cl₂):* | *7,33-7,96 (m,16H), 2,66 (t, 2H, J=7,8 Hz), 1,64-1,53 (m, 2H), 1,41-1,20 (m, 10H), 0,88 (t, 3H, J=3 Hz)* |

### III.2. 4-(5-(7-bromobenzo[c][1,2,5]thiadiazol-4-yl)-3-octylthiophen-2-yl)-N,N-diphenylaniline [GB040] à partir de GB008.

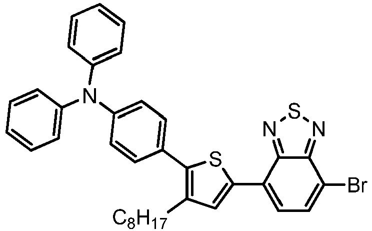

Dans un bicol sous atmosphère inerte d'argon, on introduit 1 g (2,3 mmol, 1 éq) de composé GB008. Après avoir porté le milieu à -78°C, 1,72 mL (1,1 éq, C=1,6 mol/L) de butyllithium (BuLi) sont ajoutés à la seringue. On maintient la température du milieu à -50°C et on laisse l'agitation pendant 45 min. Puis 504 mg (2,53 mmol, 1,1 éq) de chlorure de triméthylétain (CISnMe₃) sont ajoutés au milieu préalablement ramené à -78°C. La réaction reste sous agitation pendant les 3 h suivantes où la température revient à la température ambiante. Le traitement s'effectue par hydrolyse avec une solution de NH₄Cl saturée suivie d'une extraction à l'éther diéthylique. La phase éthérée est séchée sur Na₂SO₄, filtrée et concentrée. Nous obtenons alors 1,42 g du dérivé stannique de GB008 sous forme d'une huile orangée qui sera utilisée sans autre purification par la suite.

| | |
|---|---|
| *RMN ¹H (CD₂Cl₂):* | *7,33-7,18 (m,7H), 7,14-6,96 (m, 8H), 2,67 (t, 2H, J=7,8Hz), 1,67-1,50 (m, 2H), 1,41-1,19 (m,10H), 0,87 (t, 3H, J=6,6Hz). +pics stannique* |

Dans un autre tricol sous argon, un mélange de 505,5 mg (1,72 mmol, 1 éq) de dibromobenzothiadiazole et 43 mg (2% molaire) de Pd(PPh₃)₄ est réalisé dans 50 mL de DMF. Après dissolution des réactifs, nous introduisons rapidement les 1,42 g du dérivé stannique de GB008 préparé fraîchement. Le mélange est porté à la température de 95°C et agité pendant 12 h. La réaction est arrêtée par l'ajout d'une solution de NH₄Cl. On extrait la phase organique à l'éther diéthylique qui est par la suite lavée à l'eau, puis séchée sur Na₂SO₄. L'huile alors obtenue contient un mélange du composé monocouplé avec le composé bicouplé. La purification se fait sur colonne de silice avec comme éluant l'hexane suivi d'un passage progressif au mélange [hexane/CH₂Cl₂ : 6/4]. Le composé bicouplé sort le premier suivi du composé monocouplé GB040. On obtient 213,1 mg d'une huile orange (rendement de 20,0%).

| | |
|---|---|
| *RMN ¹H (CDCl₃):* | *7,99 (d, 1H, J=9Hz), 7,85 (d, 1H, J=7,6Hz), 7,71 (dd, 1H, J1=7,6Hz, J2=2Hz), 7,40-7,26 (m, 6H), 7,18-7,01 (m, 8H), 2,75 (t, 2H, J=5,8 Hz), 1,78-1,63 (m, 2H), 1,44-1,19 (m, 10H), 0,87 (t, 3H, J=6,6Hz)* |

### III.3. 4-(7-(5-(4-(diphénylamino)phényl)4-octyl thiophèn-2-yl)benzo[c][1,2,5]thiadiazol-4-yl)-benzaldéhyde [GB041].

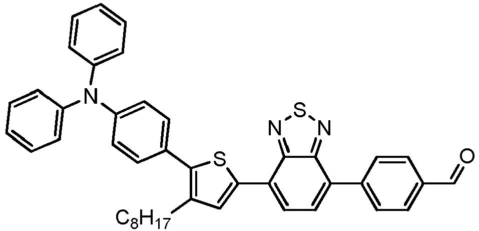

Dans un bicol, on introduit 226,2 mg (0,35 mmol, 1 éq) de composé bromé GB040 et 57,2 mg (0,38 mmol, 1,1 éq) d'acide 4-phénylboronique en présence de 2,3 éq de K₂CO₃ et 12 mg (4% molaire) de Pd(PPh₃)₄ dans 30 mL de THF anhydre. Le mélange est agité pendant 14 h à 75°C. Après un traitement du mélange avec 100 mL d'eau, la phase aqueuse est lavée par 2 × 100 mL d'éther. Les phases organiques sont lavées avec 2x100 mL de solution NaCl saturée et séchées sur Na₂SO₄. Après filtration et évaporation du solvant, la purification s'effectue sur colonne de silice avec un éluant [hexane/CH₂Cl₂ : 1/1]. On obtient 135,4 mg de composé rouge final (rendement de 58,0%).

En variante, on introduit, dans un bicol, 700 mg (1,073 mmol, 1 éq) de composé bromé GB040 et 482 mg (3,59 mmol, 3 éq) d'acide 4-phénylboronique en présence de 3 éq de K₂CO₃ et 88 mg (4% molaire) de Pd(PPh₃)₄ dans 30 mL de THF, 7 mL d'eau et 5 mL de toluène. Le mélange est agité pendant 14 h à 75°C. Après un traitement du mélange avec 100 mL d'eau, la phase aqueuse est lavée par 2 × 100 mL d'éther. Les phases organiques sont lavées avec 2 × 100 mL de solution NaCl saturée et séchées sur Na₂SO₄. Après filtration et évaporation du solvant, la purification s'effectue sur colonne de silice avec un éluant [cyclohexane/CH₂Cl₂ : 6/4]. On obtient 727 mg de composé rouge final (rendement de 70,5%).

| | |
|---|---|
| *RMN ¹H (CDCl₃):* | *10,11 (s,1H), 8,19 (d,2H, J=8,4Hz), 8,08 (s,1H), 8,07 (d, 2H, J=8,2Hz), 7,96 (d, 1H, J=7,6Hz), 7,82 (d, 1H, J=7,6Hz), 7,42-7,26 (m, 6H), 7,19-7,03 (m, 8H), 2,77 (t, 2H, J=7,8Hz), 1,80-1,66 (m, 2H), 1,45-1,19 (m, 10H), 0,87 (t, 3H, J=6,6Hz)* |

### III.4. Acide 2-cyano-3(4-(7-(5-(4-(diphényl amino)phényl)-4-octylthiophèn-2-yl)benzo[c][1,2,5]thiadiazol-4-yl)phényl)acrylique [GB043].

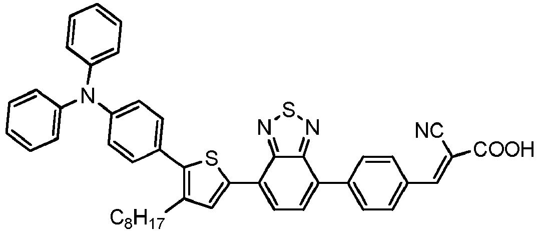

On introduit dans un bicol contenant 20 mL de CH₃CN sous atmosphère d'argon, 119,7 mg (0,18 mmol) de GB041, 18 mg (0,21 mmol, 1,2 eq) de cyanoacide acétique, quelques gouttes catalytiques de pyridine. Le tout est porté à reflux pendant 2 h. On évapore l'acétonitrile au rotavapeur et on reprend l'ensemble par du chloroforme. La phase organique est lavée successivement par une solution d'HCl 2 mol.L⁻¹, par de l'eau, puis séchée sur Na₂SO₄. Le produit désiré précipite dans un mélange d'hexane et d'éther de pétrole. Après filtration et séchage à l'étuve, on obtient 54 mg du composé GB043 sous forme de solide marron (rendement de 41,0%).

En suivant le protocole ci-dessus mais en utilisant 150 mg (0,22 mmol) de GB041 et 23 mg (0,27 mmol, 1,22 eq) de cyanoacide acétique, on obtient un rendement de 85%.

| | |
|---|---|
| *RMN ¹H (CDCl₃):* | *8,36 (s,1H), 8,16 (s, 4H), 8,06 (s, 1H), 7,91 (d, 1H, J=7,4Hz), 7,79 (d, 1H, J=7,6Hz), 7,40-7,26 (m, 6H), 7,18-7,03 (m, 8H), 2,74 (t, 2H, J=7,8Hz), 1,78-1,66 (m, 2H), 1,42-1,21 (m, 10H), 0,87 (t, 3H, J=6,6Hz).* |

### III.5. 4-(5-(5,5-diméthyl-1,3,2-dioxaborinan-2-yl)-3-octylthiophen-2-yl)-N,N-diphénylaniline [YKP85].

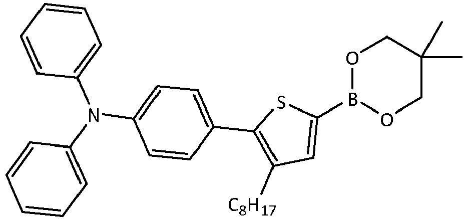

Sous atmosphère d'argon, on dissout dans un tricol 2 g (4,55 mmol, 1 éq) de 2-triphénylamino-3-octylthiophène avec 30 mL de THF. Après avoir porté le milieu à -78°C, 2,2 mL (5,46 mmol, 1,2 éq, C = 2,5 mol/L) de BuLi sont ajoutés goutte à goutte. La réaction est agitée pendant 1 h à -50°C. Puis 1,55 mL (13,65 mmol, 3 éq) de triméthylborate est ajouté au milieu préalablement ramené à -78°C. La réaction reste sous agitation pendant les 2 h suivantes où la température remonte à l'ambiante. Le mélange est ensuite hydrolysé par une solution de HCl 2 mol/L et extrait avec 2 x 50 mL d'éther éthylique. Durant le séchage de la phase organique recueillie sur Na₂SO₄, 1,18 g (11,38 mmol, 2,5 éq) de 2,2-diméthyl-1,3-propanediol sont ajoutés. Après 60 min d'agitation, le mélange est filtré et concentré au rotavapeur. La purification s'effectue sur colonne de silice avec un éluant [CHCl₃/Cyclohexane : 4/6]. On obtient 2,09 g d'une huile jaune (rendement de 83,3%).

| | |
|---|---|
| *RMN ¹H (CDCl₃):* | *7,47 (s, 1H), 7,08-7,36 (m,16H), 3,80 (s,4H), 2,66 (t, 2H, J=7,8 Hz), 1,64-1,53 (m, 2H), 1,41-1,20 (m, 10H), 1,02 (s,6H), 0,88 (t, 3H, J=3 Hz)* |

### III.6. 4-(5-(7-bromobenzo[c][1,2,5]thiadiazol-4-yl)-3-octylthiophen-2-yl)-N,N-diphenylaniline [GB040] à partir de YKP85.

Dans un tricol sous atmosphère d'argon, on introduit 1,385 g (2,51 mmol, 1,1 éq) de YKP85 en présence de 804 mg (1 éq) de dibromobenzothiadiazole, 1,03 mg de K₂CO₃ (3 eq), 40 mL de THF, 10 mL d'eau. Le tout est agité pendant 30 min à 60°C. On injecte par la suite 106 mg (5% molaire) de Pd(PPh₃)₄ à la solution limpide de couleur bordeaux. Le tout est agité pendant 12 h à 70°C. Après un retour à température ambiante, le contenu du ballon est versé dans 100 mL d'eau. On extrait la phase organique par 2 × 100 mL d'éther. Les phases organiques rassemblées sont lavées respectivement par de l'eau et par 2 × 100 mL de solution NaCl saturée. Après séchage Na₂SO₄, filtration et évaporation du solvant, la purification s'effectue sur colonne d'alumine avec l'éluant [cyclohexane/CH₂Cl₂ : 6/4]. On obtient 1,05 g de composé final GB0040 sous forme d'huile (rendement de 64,2%).

| | |
|---|---|
| *RMN ¹H (CDCl₃):* | *7,99 (d, 1H, J=9Hz), 7,85 (d, 1H, J=7,6Hz), 7,71 (dd, 1H, J1=7,6Hz, J2=2Hz), 7,40-7,26 (m, 6H), 7,18-7,01 (m, 8H), 2,75 (t, 2H, J=5,8 Hz), 1,78-1,63 (m, 2H), 1,44-1,19 (m, 10H), 0,87 (t, 3H, J=6,6Hz)* |

### III.7. Diéthyl(1-cyano-2(4-(7-(5-(4-(diphénylamino)phényl)-4-octylthiophen-2-yl)benzo[c]1,2,5]thiadiazol-4-yl)phényl)vinyl)phosphonate [YKP115].

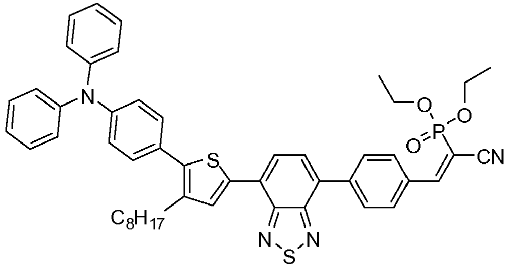

Une autre condensation de Knoevenagel est réalisée en introduisant dans un bicol contenant 15 mL de CH₃CN sous atmosphère d'argon, 155 mg (0,23 mmol) de GB041, 61 mg (0,34 mmol, 1,5 eq) de diéthylcyanométhylphosphonate, quelques gouttes catalytiques de pyridine. Le tout est porté à reflux pendant 2 h. On évapore l'acétonitrile au rotavapeur et on reprend l'ensemble par du chloroforme. La phase organique est lavée par de l'eau, puis séchée sur Na₂SO₄. Après filtration et évaporation, le produit brut est purifié sur colonne de chromatographie sur silice [éluant : CH₂Cl₂/Acétonitrile : 9/1] dont on obtient 145 mg du composé YKP115 (rendement de 93,5%).

| | |
|---|---|
| *RMN ¹H (CD₂Cl₂):* | *8,13 (dd,4H), 8,08 (s,1H), 8,03 (d,1H, J=21hz), 7,94 (d, 1H, J=7,52Hz), 7,82 (d, 1H, J=7,54Hz), 7,38 (dt, 2H, J=8,7Hz), 7,28 (td, 4H), 7,13-7,04 (m, 7H), 4,18 (m, 4H), 2,75 (q, 2H), 1,,7 (q, 2H), 1,39 (t, 6H), 1,25 (m, 10H), 0,85 (t, 3H)* |
| *RMN ³¹P(CD₂Cl₂):* | *12,34 (s)* |

### III.8. Acide (1-cyano-2(4-(7-(5-(4-(diphénylamino)phényl)-4-octylthiophen-2-yl)benzo[c][1,2,5]thiadiazol-4-yl)phényl)vinyl)phosphonique [YKP126].

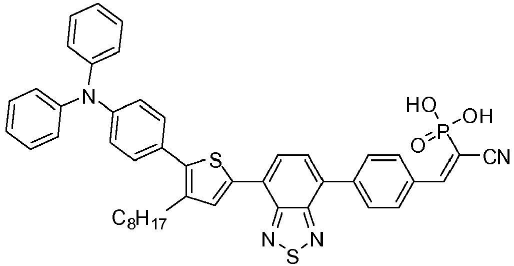

Dans un bicol, on place YKP115 dans 10 mL de CH₂Cl₂ à reflux pendant 30 min et on ajoute par injection BrSi(Me)₃ en large excès et on laisse 1 h à reflux. On refroidit, on évapore le dichlorométhane et on sépare par chromatographie, THF-Méthanol (9-1) comme éluant. On obtient un solide orangé rouge.

### III.9. 5-(7-(5-(4-(diphenylamino)phenyl)4-octylthiophen-2-yl)benzo[c]1,2,5] thiadiazol-4-yl)-isophthalaldéhyde [YKP120].

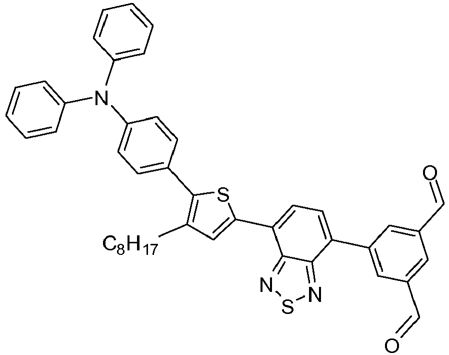

Dans un bicol, on introduit 500 mg (0,766 mmol, 1 éq) de composé bromé GB040 et 205 mg (1,15 mmol, 1,5 éq) d'acide 3,5-diformylphénylboronique en présence de 3 éq de K₂CO₄ et 44 mg (4% molaire) de Pd(PPh₃)₄ dans 35 mL de THF, 2,5 mL d'eau et 2 mL de toluène. Le mélange est agité pendant 14 h à 75°C. Après un traitement du mélange avec 100 mL d'eau, la phase aqueuse est lavée par 2 × 100 mL d'éther. Les phases organiques sont lavées avec 2 × 100 mL de solution NaCl saturée et séchées sur Na₂SO₄. Après filtration et évaporation du solvant, la purification s'effectue sur colonne de silice avec un éluant [hexane/Ether éthylique : 8/2]. On obtient 416 mg de composé rouge final (rendement de 76,93%).

| | |
|---|---|
| *RMN ¹H (CD₂Cl₂):* | *10,18 (s, 2H), 8,77 (d, 2H, J=1,53Hz), 8,39 (t, 1H, J=1,53Hz), 8,09 (s, 1H), 7,92 (dd, 2H, J1=7,53Hz, J2=19,35Hz), 7,39-7,23 (m, 6H), 7,13-7,00 (m, 8H), 2,74 (t, 2H, J=7,8Hz), 1,69 (m, 2H), 1,45-1,19 (m, 10H), 0,83 (t, 3H, J=6,6Hz)* |

### III.10. Acide (2E,2E')-3.3'-(5-(7-(5-(4-(diphénylamino)phényl)-4-octylthiophen-2-yl)benzo[c][1,2,5]thiadiazol-4-yl)-1,3-phénylène)bis(2-cyanoacrylique) [YKP125].

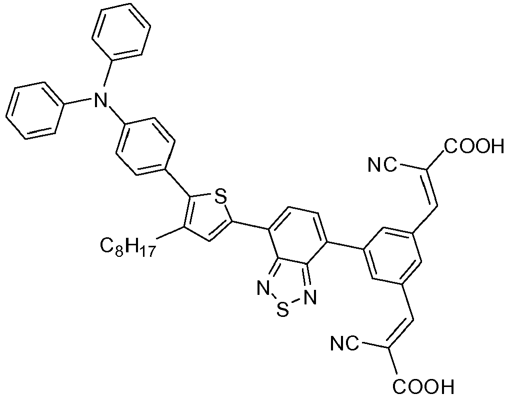

On introduit dans un bicol contenant 20 mL de CH₃CN sous atmosphère d'argon, 150 mg (0,21 mmol) de YKP120, 200 mg (2,35 mmol, 11 eq) de cyanoacide acétique, quelques gouttes catalytiques de pyridine. Le tout est porté à reflux pendant 2 h. On évapore l'acétonitrile au rotavapeur et on reprend l'ensemble par de l'éther éthylique. La phase organique est lavée successivement par une solution d'HCl 2 mol.L⁻¹, par de l'eau, puis séchée sur Na₂SO₄. Le produit désiré se solubilise dans un minimum de THF et précipite dans du pentane. Après filtration et séchage à l'étuve, on obtient 176,5 mg du composé YKP125 sous forme de solide bordeaux (rendement de 98,6%).

| | |
|---|---|
| *RMN ¹H (DMSO):* | *14,05 (s, 2H), 8,85 (s,2H), 8,46 (s, 1H), 8,41 (s, 2H), 8,16 (d, 1H, J=7,52Hz), 8,09 (s, 1H), 9,98 (d, 1H, J=7,51Hz), 7,41-7,29 (m, 6H), 7,11-6,99 (m, 8H), 2,74 (t, 2H, J=7,8Hz), 1,69 (m, 2H), 1,45-1,19 (m, 10H), 0,83 (t, 3H, J=6,6Hz)* |

### IV. Préparation du colorant GB062 (faisant partie de l'invention).

### IV.1. 5,5-diméthyl-2-(4-octylthiophèn-2-vl)-1,3,2-dioxaborinane [GB036].

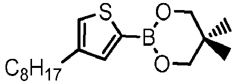

Sous atmosphère d'argon, on dissout dans un tricol 3 g (15,28 mmol, 1 éq) de 3-octylthiophène avec 30 mL de THF. Après avoir porté le milieu à -78°C, 12 mL (18,34 mmol, 1,2 éq, C=1,6 mol/L) de BuLi sont ajoutés goutte à goutte. La réaction est agitée pendant 1 h à -50°C. Puis 8 mL (30,56 mmol, 2 éq) de tributylborate sont ajoutés au milieu préalablement ramené à -78°C. La réaction reste sous agitation pendant les 2 h suivantes où la température remonte à la température ambiante. Le mélange est ensuite hydrolysé par une solution de HCl 2 mol.L⁻¹ et extrait avec 2 x 50 mL d'éther éthylique. Durant le séchage de la phase organique recueillie sur Na₂SO₄, 4,8 g (45,84 mmol, 3 éq) de 2,2-diméthyl-1,3-propanediol sont ajoutés. Après 45 min d'agitation, le mélange est filtré et concentré au rotavapeur. La purification s'effectue sur colonne de silice avec un éluant [hexane/Et2O : 9/1]. On obtient 3,40 g d'une huile jaune (rendement de 72,0%).

| | |
|---|---|
| *RMN ¹H (CDCl₃):* | *7,40 (d, 1H, J=1,2Hz), 7,15 (d, 1H, J=1,2Hz), 3,75 (s, 4H), 2,61 (t, 2H, J=8Hz), 1,68-1,52 (m, 2H), 1,40-1,20 (m, 10H), 1,02 (s, 6H), 0,88 (t, 3H, J=6,5Hz).* |

### IV.2. 4,7-bis(4-octylthiophen-2-yl)benzo[c][1,2,5]thiadiazole [GB051].

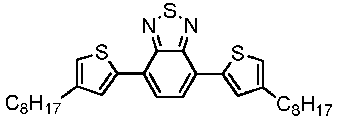

Sous atmosphère d'argon, on dissout dans un tricol 1,99 g (6,45 mmol, 2,4 éq) de GB036 et 790 mg (2,69 mmol, 1 éq) de dibromobenzo[c][1,2,5]thiadiazole en présence de 1,31 g (6,45 mmol, 2,4 éq) de K₃PO₄ et 93,2 mg (3% molaire) de Pd(PPh₃)₄ dans 30 mL de DMF anhydre. Le mélange est agité pendant 14 h à 75°C. Après un traitement du mélange avec 100 mL d'eau, la phase aqueuse est lavée par 2 × 100mL d'éther. Les phases organiques rassemblées sont ensuite lavées par 2 × 100 mL de solution saturée de NaCl et séchées sur Na₂SO₄. Après filtration et évaporation du solvant, la purification s'effectue sur colonne de silice avec un éluant [hexane/CH₂Cl₂ : 8 /2]. On obtient à la suite de cette colonne, 233,4 mg de composé final (rendement de 17,0%).

En variante, sous atmosphère d'argon, on dissout, dans un tricol, 2,15 g (6,97 mmol, 2,2 éq) de GB036 et 937 mg (3,18 mmol, 1 éq) de dibromobenzo[c][1, 2, 5]thiadiazole en présence de 1,5 g (6,45 mmol, 2,4 éq) de K₂CO₃ et 185 mg (5% molaire) de Pd(PPh₃)₄ dans un mélange de 50 mL de THF, 10 mL d'eau et 15 mL de toluène préalablement dégazé. Le mélange est agité pendant 14 h à 75°C. Après un traitement du mélange avec 100 mL d'eau, la phase aqueuse est lavée par 2 × 100mL d'éther. Les phases organiques rassemblées sont ensuite lavées par 2 × 100 mL de solution NaCl(sat) et séchées sur Na₂SO₄. Après filtration et évaporation du solvant, la purification s'effectue sur colonne de silice avec un éluant [hexane/CH₂Cl₂ : 8/2]. On obtient à la suite de cette colonne, 1,3 g de composé final (rendement de 77,5%).

| | |
|---|---|
| *RMN ¹H (CD₂Cl₂):* | *8,08 (s, 1H), 8,07 (s, 1H), 7,93 (s, 2H), 7,15 (s, 1H), 7,14 (s, 1H), 2,79 (t, 4H, J=7,2Hz), 1,88-1,73 (m, 4H), 1,53-1,34 (m, 20H), 0,98 (t, 6H, J=6,6Hz).* |

### IV.3. 4,7-bis(5-bromo-4-octylthiophen-2-yl)benzo[c][1,2,5]thiadiazole [GB054].

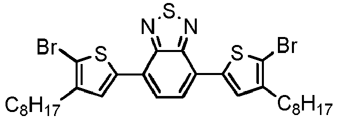

Dans un tricol sous argon, on solubilise 238,2 mg (0,45 mmol, 1éq) du synthon GB051 dans 20 mL de DMF. A température ambiante, un mélange de 177,9 mg (1,00 mmol, 2,2 éq) de N-bromosuccinimide et de 10 mL de DMF est ajouté goutte à goutte. Le mélange est alors laissé sous agitation pendant 24 h. Le milieu est ensuite hydrolysé par une solution d'HCl 1 mol.L⁻¹ et extrait à l'éther éthylique. Les phases organiques rassemblées sont lavées par une solution saturée de NaCl puis séchées sur Na₂SO₄ anhydre. Après filtration et évaporation du solvant, la purification s'effectue sur colonne de silice avec l'éluant [hexane]. On obtient 219,8 mg d'un solide rouge (rendement de 71,0%).

En variante, dans un tricol sous argon, on solubilise 2 g (3,83 mmol, 1éq) du synthon GB051 dans 50 mL de CHCl₃. A température ambiante, un mélange de 177,9 mg (1,00 mmol, 2,2 éq) de N-bromosuccinimide et de 50 mL de CHCl₃ est ajouté goutte à goutte. Le mélange est alors laissé sous agitation pendant 24 h. Le milieu est ensuite hydrolysé par une solution d'HCl 1 mol.L⁻¹ et extrait à l'éther éthylique. Les phases organiques rassemblées sont lavées par une solution saturée de NaCl puis séchées sur Na2SO4 anhydre. Après filtration et évaporation du solvant, la purification s'effectue sur colonne de silice avec l'éluant [hexane]. On obtient 2,60 g d'un solide rouge (rendement de 99,2%).

| | |
|---|---|
| *RMN ¹H (CDCl₃):* | *7,77 (s, 2H), 7,75 (s, 2H), 2,64 (t, 4H, J=7,2Hz), 1,73-1,59 (m, 4H), 1,43-1,26 (m, 20H), 0,88 (t, 6H, J=6,5Hz).* |

### IV.4. 4,7-bis(3-octyl-[2,2'-bithiophen]-5-yl)benzo[c][1,2,5]thiadiazole[GB055].

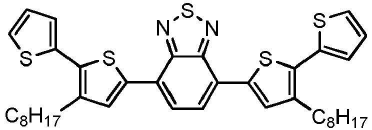

Sous atmosphère d'argon, on dissout dans un tricol 217,3 mg (0,32 mmol, 1 éq) de GB054 et 97,4 mg (0,76 mmol, 2,4 éq) d'acide 2-thiophenboronique en présence de 155,3 mg (0,76 mmol, 2,4 éq) de K₃PO₄ et 15 mg (4% molaire) de Pd(PPh₃)₄ dans 30 mL de DMF anhydre. Le mélange est agité pendant 14 h à 75°C. Après un traitement du mélange avec 100 mL d'eau, la phase aqueuse est lavée par 2 × 100mL d'éther. Les phases organiques rassemblées sont ensuite lavées par 2 × 100 mL de solution saturée de NaCl et séchées sur Na₂SO₄. Après filtration et évaporation du solvant, la purification s'effectue sur colonne de silice avec un éluant [hexane/CH₂Cl₂ : 8 /2]. On obtient à la suite de cette colonne, 50,2 mg de poudre rose (rendement de 23,0%).

En variante, sous atmosphère d'argon, on dissout, dans un tricol, 1,90 g (2,78 mmol, 1 éq) de GB054 et 747 mg (5,85 mmol, 2,2 éq) d'acide 2-thiopheneboronique en présence de 1,09 g (7,88 mmol, 3 éq) de K₂CO₃ et 153 mg (5% molaire) de Pd(PPh₃)₄ dans 50 mL de THF et 5 mL d'eau dégazé. Le mélange est agité pendant 14 h à 75°C. Après un traitement du mélange avec 100 mL d'eau, la phase aqueuse est lavée par 2 × 100 mL d'éther. Les phases organiques rassemblées sont ensuite lavées par 2 × 100mL de solution NaCl(sat) et séchées sur Na₂SO₄. Après filtration et évaporation du solvant, la purification s'effectue sur colonne de silice avec un éluant [cyclohexane/CHCl₃ : 95/5]. On obtient à la suite de cette colonne, 790 mg de poudre rose (rendement de 43,5%).

| | |
|---|---|
| *RMN ¹H (CDCl₃):* | *7,99 (s, 2H), 7,83 (s, 2H), 7,36 (dd, 2H, J₁=5Hz, J₂=1,2Hz), 7,25 (dd, 2H, J₁=3,6Hz, J₂=1,2Hz), 7,13 (dd, 2H, J₁=5,2Hz, J₂=3,6Hz), 2,85 (t, 4H, J=7,2Hz), 1,83-1,55 (m, 4H), 1,47-1,21 (m, 20H), 0,88 (t, 6H, J=6,6 Hz).* |

### IV.5. 4,7-bis(5'-bromo-3-octyl-[2,2'-bithiophen]-5-yl])benzo[c][1,2,5] thiadiazole [GB056].

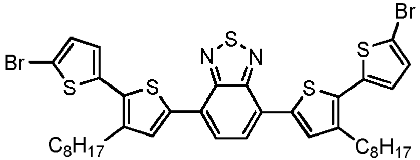

Dans un tricol sous argon, on solubilise 50,2 mg (0,07 mmol, 1 éq) du synthon GB055 dans 20 mL de DMF (ou de CDCl₃). A température ambiante, un mélange de 27,2 mg (0,15 mmol, 2,1 éq) de N-bromosuccinimide et de 10 mL de DMF (ou de CDCl₃) est ajouté goutte à goutte. Le mélange est alors laissé sous agitation pendant 4 h. Le milieu est ensuite hydrolysé par une solution d'HCl 1 mol.L⁻¹ et extrait à l'éther éthylique. Les phases organiques rassemblées sont lavées par une solution saturée de NaCl puis séchées sur Na₂SO₄ anhydre. Après filtration et évaporation du solvant, la purification s'effectue sur colonne de silice avec l'éluant [hexane/CH₂Cl₂ : 95/5]. On obtient 56,8 mg un solide bordeaux (rendement de 92,0%).

| | |
|---|---|
| *RMN ¹H (CDCl₃):* | *7,95 (s, 2H), 7,81 (s, 2H), 7,05 (d, 2H, J=3,8Hz), 6,97 (d, 2H, J=3,8Hz), 2,79 (t, 4H, J=7,8Hz), 1,78-1,64 (m, 4H), 1,48-1,21 (m, 20H), 0,89 (t, 6H, J=6,6 Hz).* |

### IV.6. 4-(5'-(7-(5'-bromo-3-octyl-[2,2'-bithiophen]-5-yl)benzo[c][1,2,5] thiadiazol-4-yl)-3'-octyl-[2,2'-bithiophen]-5-yl)-N,N'-diphenylaniline [GB060].

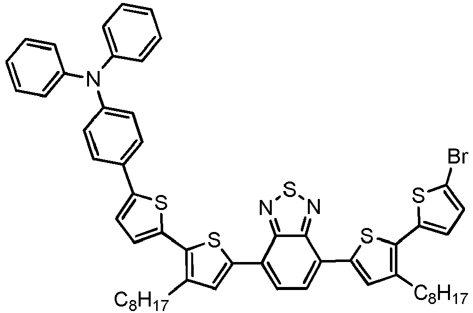

Dans un tricol sous atmosphère d'argon, on introduit 70 mg (0,19 mmol, 1,1 éq) de 4-(diphénylamino)phénylboronique et 151,1 mg (0,18 mmol, 1 éq) de GB056 en présence de 40 mg (1,1 éq) de K₃PO₄ et 8 mg (4% molaire) de Pd(PPh₃)₄ dans 30 mL d'un mélange [DMF/toluène : 2/1]. Le tout est agité pendant 14 h à 75°C. Après un traitement du mélange avec 100 mL d'eau, la phase aqueuse est lavée par 2×100 mL d'éther. Les phases organiques sont lavées avec 2×100 mL de solution NaCl saturée et séchées sur Na₂SO₄. Après filtration et évaporation du solvant, la purification s'effectue sur colonne de silice avec un éluant [hexane/CH₂Cl₂ : 8/2]. On obtient 42,3 mg de composé final GB060 (rendement de 23,5%).

En variante, sous atmosphère d'argon, on dissout, dans un tricol, 500 mg (0,59 mmol, 1 éq) de GB056, 245 mg (3 éq) de K₂CO₃ et 35 mg (5% molaire) de Pd(PPh₃)₄ dans 30 mL de THF et 5 mL d'eau dégazé. Après 30 min d'agitation à 60°C, on injecte 190 mg (0,53 mmol, 0,9 éq) de 4-(diphénylamino)phénylboronique dissout dans 20 mL de THF. Le tout est agité pendant 14 h à 75°C. Après un traitement du mélange avec 100 mL d'eau, la phase aqueuse est lavée par 2×100mL d'éther. Les phases organiques sont lavées avec 2 × 100 mL de solution NaCl saturée et séchées sur Na₂SO₄. Après filtration et évaporation du solvant, la purification s'effectue sur colonne de silice avec un éluant [cyclohexane/CHCl₃ : 8/2]. On obtient 242 mg de composé final (rendement de 40,6%).

| | |
|---|---|
| *RMN ¹H (CDCl₃):* | *7,97 (d, 2H), 7,84 (s, 2H), 7,49 (dt, 2H), 7,31-7,17 (m, 7H), 7,12-6,97 (m, 9H), 2,82 (m, 4H), 1,70 (m, 4H), 1,48-1,21 (m, 20H), 0,86 (t, 6H)* |

### IV.7. 4-(5'-(7-(5'-(4-(diphénylamino)phényl)-3-octyl-[2,2'-bithiophèn]-5-yl)benzo[c][1,2,5]thiadiazol-4-yl)-3'-octyl-[2,2'-bithiophèn]-5-yl)benzaldéhyde [GB061].

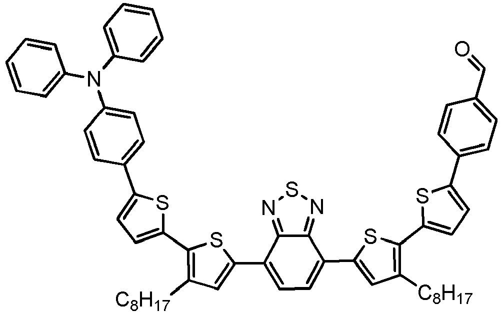

Dans un tricol sous atmosphère d'argon, on introduit 22 mg (0,147 mmol, 1,5 éq) d'acide 4-formylphénylboronique et 97,9 mg (0,097 mmol, 1 éq) de GB060 en présence de 1 mL d'une solution de K₂CO₃ (2 mol/L), 1 mL d'éthanol et 4 mg (4% molaire) de Pd(PPh₃)₄ dans 20 mL de THF. Le tout est agité pendant 14 h à 75°C. Après un traitement du mélange avec 100 mL d'eau, la phase aqueuse est lavée par 2×100 mL d'éther. Les phases organiques sont lavées avec 2×100 mL de solution NaCl saturée et séchées sur Na₂SO₄. Après filtration et évaporation du solvant, la purification s'effectue sur colonne de silice avec un éluant [hexane/CH₂Cl₂ : 5/2]. On obtient 92,1 mg de composé final GB061 (rendement de 92%).

En variante, dans un tricol sous atmosphère d'argon, on introduit 53,4 mg (0,356 mmol, 1,5 éq) d'acide 4-formylphénylboronique et 240 mg (0,237 mmol, 1éq) de GB060 en présence de 98 mg (3 eq) de K₂CO₃. Le tout est dissout dans un mélange préalablement dégazé de 2,5 mL d'eau et 25 mL de THF. Après 30 min d'agitation à 60°C, on ajoute 13,7 mg (5% molaire) de Pd(PPh₃)₄ dans le milieu réactionnel. Le tout est agité pendant 14 h à 75°C. Après un traitement du mélange avec 100 mL d'eau, la phase aqueuse est lavée par 2×100mL d'éther. Les phases organiques sont lavées avec 2 × 100 mL de solution NaCl saturée et séchées sur Na₂SO₄. Après filtration et évaporation du solvant, la purification s'effectue sur colonne de silice avec un éluant [cyclohexane/CH₂Cl₂ : 6/4]. On obtient 240 mg de composé final GB061 (rendement de 97,7%).

| | |
|---|---|
| *RMN ¹H (CD₂Cl₃):* | *9,84 (s, 1H), 7,86-7,65 (m, 6H) 7,37 (m, 4H), 7,35-6,91 (m, 16H), 2,72 (m, 4H), 1,63 (m, 4H), 1,48-1,21 (m, 20H), 0, 77 (t, 6H)* |

### IV.8. Acide 2-cyano-3-(4-(5'-(7-(5'-(4-(diphénylamino)phényl)-3-octyl-[2,2'-bithiophènl-5-yl)benzo[c][1,2,5]thiadiazol-4-yl)-3'-octyl-[2,2'-bithiophèn]-5-yl)phényl)acrylique [GB062].

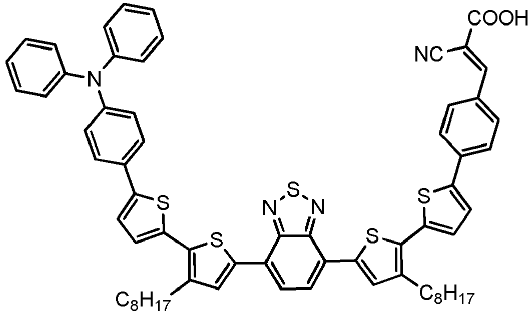

On introduit dans un tricol contenant 20 mL de mélange [CH₃CN/CHCl₃ : 1/1] sous atmosphère d'argon, 92,1 mg (0,089 mmol) de GB061, 15 mg (0,178 mmol, 2 eq) de l'acide cyanoacétique et quelques gouttes catalytiques de pyridine. Le tout est porté à reflux pendant 4 h. On évapore l'acétonitrile sous pression réduite et on reprend l'ensemble par du chloroforme. La phase organique est lavée successivement par une solution d'HCl 2 mol.L⁻¹, par de l'eau, puis séchée sur Na₂SO₄. Le produit désiré précipite dans un mélange d'hexane et d'éther de pétrole. Après filtration, lavage au pentane et séchage à l'étuve, on obtient 58 mg du composé GB062 sous forme de poudre noire (rendement de 60,0%).

En variante, on introduit, dans un bicol contenant 30 mL de CH₃CN, sous atmosphère d'argon, 210 mg (0,20 mmol) de GB061, 26 mg (0,30 mmol, 1,5 eq) d'acide cyanoacétique, quelques gouttes catalytiques de pyridine. Le tout est porté à reflux pendant 2 h. On évapore l'acétonitrile au rotavapeur et on reprend l'ensemble par du chloroforme. La phase organique est lavée successivement par une solution d'HCl 2M, par de l'eau, puis séchée sur Na₂SO₄. Après une colonne de chromatographie sur silice avec l'éluant [THF/MeOH : 9/1], on obtient le composé GB062 sous forme d'une poudre noire-violette (rendement de 78,25%).

| | |
|---|---|
| *RMN ¹H (CDCl₃):* | *7.88-8.10 (m, 6H), 7.76 (d, 2H, J= 8Hz), 7.50-7.65 (m, 3H, j= 7.6Hz), 7.20-7.40 (m, 8H, J=7,6Hz and 3.05Hz), 6.90-7.13 (m, 8H, J=8,2Hz), 6.90-7.13 (m, 8H, J=8,2Hz), 3.1 (s, br, 1H), 1.60-1.75 (m,4H), 1.21-1.50 (m, 20H); 0.71-0.95 (m, 6H).* |

### V. Préparation du colorant YKP73 (ne faisant pas partie de l'invention).

### V.1. 3-(4-octylphényl)thiophène [YKP67].

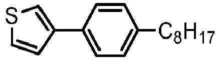

Dans un tricol sous atmosphère d'argon, on introduit 4,49 g (0,097 mmol, 1,1 éq) de 4-bromo-octylbenzène en présence de 6,5 g de K₂CO₃ (3 eq), 20 mL de toluène, 1 mL d'eau et 4 mg (4% molaire) de Pd(PPh₃)₃ fraîchement synthétisé selon le protocole ci-dessous décrit. Le tout est agité pendant 30 min à 60°C. Après avoir dissous 2 g (15,63 mmol, 1éq) d'acide 3-thiophène-boronique dans 10 mL de toluène, la solution obtenue est incorporée goutte à goutte au mélange réactionnel. Le tout est agité pendant 12 h à 110°C. Après un retour à température ambiante, le contenu du ballon est versé dans 100 mL d'eau. On extrait la phase organique par 2×100 mL d'éther. Les phases organiques rassemblées sont lavées respectivement par de l'eau et par 2×100 mL de solution NaCl saturée. Après séchage sur du Na₂SO₄, filtration et évaporation du solvant, la purification s'effectue sur colonne de silice avec de l'hexane. On obtient 1,61 g de cristaux blanc de composé final YKP67 (rendement de 40%).

| | |
|---|---|
| *RMN ¹H (CDCl₃):* | *7,56 (dt, 2H, J=8,3Hz, J=1,9Hz), 7,41-7,47 (m, 3H), 7,26 (dt, 2H, J=8,3Hz, J=1,9Hz), 2,10 (t, 2H), 1,69 (m, 2H, J=7,8Hz), 1,33 (m, 10H), 0,94 (t, 3H).* |

Le Catalyseur : Pd(PPh₃)₃ à 5% molaire.

Le catalyseur est synthétisé par réaction de la tri(phényl)phosphine (PPh₃) sur le palladium acétate II (Pd(OAc)₂). Dans un bicol, on introduit 175 mg (1 eq) de Pd(OAc)₂ et 205 mg (4 eq) de PPh₃. Sous argon, 10 mL de THF anhydre sont ajoutés et le tout est porté à la température de 60°C pendant 30 min. On obtient alors le catalyseur Pd(PPh₃)₃ de couleur jaune poussin prêt à être injecté au milieu réactionnel.

### V.2. 2-bromo-3-(4-octylphenyl)thiophene [YKP69].

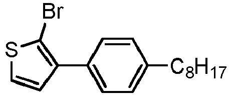

Dans un tricol sous argon, 1,40 g (5,14 mmol) de YKP67 dans 40 mL de DMF est refroidi à 0°C. 915 mg (5,14 mmol, 1 eq) de N-bromosuccinimide sont solubilisés dans 20 mL de mélange [DMF/MeOH : 1/1]. Cette solution de NBS (protégée de la lumière) est ensuite additionnée goutte à goutte (30 min) sur le milieu réactionnel. On laisse ensuite la température du milieu remonter à température ambiante en 2 h. Le milieu est hydrolysé par une solution d'HCl 1 mol.L⁻¹ et extrait à l'éther éthylique. Les phases organiques rassemblées sont lavées par une solution saturée de NaCl puis séchées sur du Na₂SO₄ anhydre. Après séchage sur du Na₂SO₄, filtration et évaporation du solvant, la purification s'effectue sur colonne de silice au cyclohexane. On obtient 1,58 g de composé final YKP69 sous forme d'une huile translucide (rendement de 85,7%).

| | |
|---|---|
| *RMN ¹H (CDCl₃):* | *7,51 (dt, 2H), 7,34 (d, 1H, J=0,69Hz), 7,32 (d, 1H, J=0,69Hz), 7,07 (dt, 2H), 2,68 (t, 2H), 1,35 (m, 2H), 1,33 (m, 10H), 0,94 (t, 3H).* |

### V.3. 4-(2-(3-(4-octylphenyl)thiophen-2-yl)vinyl)-N,N-diphenylaniline [YKP70].

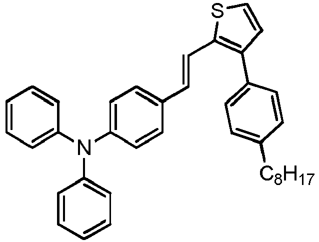

Dans un tricol sous argon, on introduit, dans l'ordre successif, 1,20 g (3,41 mmol, 1 eq) de YKP69, 34 mg (1%) du catalyseur trans-di(n-acetato)bis[o-(di-o-tolylphosphino)benzyl] dipalladium(II), 159 mg (20%) de 2,6-di-tert-butylcrésol et 795 mg (2,2 eq) de carbonate de sodium. Le tout après dissolution dans 25 mL de DMAC préalablement dégazé est porté à 90°C. Une solution de 15 mL de DMAC contenant 1,855 g (6,86 mmol, 2 eq) de YKP21 est ajoutée goutte à goutte à notre mélange. Après l'ajout, le tout est porté à 140°C et agité pendant 24 h. Le lendemain après refroidissement, le contenu du tricol est ajouté à 200 mL de mélange de [CH₂Cl₂/eau : 50/50]. La phase organique est lavée successivement par une solution d'HCl 2 mol.L-1, par de l'eau, par une solution saturée de NaCl puis séchée sur du Na₂SO₄. Après filtration et évaporation, le produit brut est purifié sur colonne de chromatographie sur alumine avec de l'héxane. On obtient après cette réaction de Heck, 1,47 g du composé YKP70 sous forme d'un solide visqueux jaune (rendement de 79,0%).

| | |
|---|---|
| *RMN ¹H (CDCl₃):* | *7,27-7,45 (m, 13H), 6,99-7,25 (m, 9H), 2,68 (t, 2H), 1,69 (m, 2H), 1,30 (m, 10H), 0,91 (t, 3H).* |

### V.4. 4-(2-(5-bromo-3-(4-octyphenyl)thiophen-2-yl)vinyl)-N,N-diphenyaniline [YKP72].

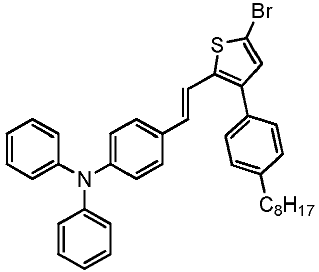

Dans un tricol sous argon, 1,00 g (1,85 mmol, 1eq) de YKP70 dans 20 mL de DMF sont refroidis à -10°C. 328 mg (1,85 mmol, 1eq) de N-bromosuccinimide sont solubilisés dans 10 mL de mélange [DMF/MeOH : 1/1]. Cette solution de NBS (protégée de la lumière) est ensuite additionnée goutte à goutte (30 min) sur le milieu réactionnel. On laisse ensuite la température du milieu remonter à température ambiante en 2 h. Le milieu est hydrolysé par une solution d'HCl 1 mol.L⁻¹ et extrait à l'éther éthylique. Les phases organiques rassemblées sont lavées par une solution saturée de NaCl puis séchées sur Na₂SO₄ anhydre. Après séchage Na₂SO₄, filtration et évaporation du solvant, la purification s'effectue sur colonne d'alumine neutre avec l'éluant [Hexane/CHCl3 : 100/1]. On obtient 742 mg de composé final YKP69 sous forme d'une huile translucide (rendement de 64,6%).

| | |
|---|---|
| *RMN ¹H (AcétoneD):* | *7,25-7,48 (m, 12H), 6,92-7,18 (m, 9H), 2,70(t, 2H), 1,69 (m, 2H), 1,32 (m, 10H), 0,90 (t, 3H).* |

### V.5. 4-(5-(4-(diphénylamino)sthyryl)-4-(4-octyl phényl)thiophèn-2-yl)benzaldehyde [YKP73].

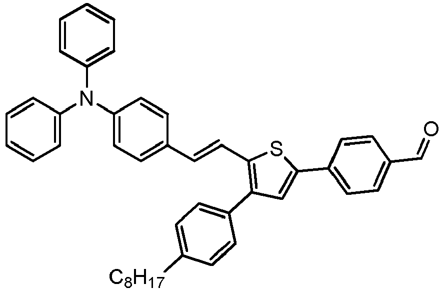

Dans un tricol sous atmosphère d'argon, on introduit 740 mg (1,19 mmol, 1,1 éq) de YKP72 en présence de 824 mg de K₂CO₃ (5 eq), 20 mL de toluène, 1 mL d'eau et 48 mg (5% molaire) de Pd(PPh₃)₄. Le tout est agité pendant 30 min à 60°C. Après avoir dissous 270 g (1,79 mmol, 1,5 éq) d'acide 4-formylphénylboronique dans 10 mL de toluène, cette solution est incorporée goutte à goutte au mélange réactionnel. Le tout est agité pendant 12 h à 90°C. Après un retour à température ambiante, le contenu du ballon est versé dans 100 mL d'eau. On extrait la phase organique par 2 × 100 mL d'éther. Les phases organiques rassemblées sont lavées respectivement par de l'eau et par 2 × 100 mL de solution NaCl saturée. Après séchage sur du Na₂SO₄, filtration et évaporation du solvant, la purification s'effectue sur colonne d'alumine avec l'éluant [cyclohexane/Et₂O : 98/2]. On obtient le composé final YKP73 sous forme de cristaux de couleur jaune citron préalablement recristallisés dans du pentane (rendement 63,5%).

| | |
|---|---|
| *RMN ¹H (CD₂Cl₂):* | *10,07 (s, 1H), 7,97 (dt, 2H), 7,81 (dt, 2H), 7,63 (dt, 2H), 7,27-7,45 (m, 9H), 6,99-7,25 (m, 10H), 2,70 (t, 2H), 1,70 (m, 2H), 1,33 (m, 10H), 0,93 (t, 3H).* |

### V.6. Acide 2-cyano-3-(4-(5-(4-(diphénylamino)styryl)-4-(4-octylphényl)thiophèn-2-yl)phényl)acrylique [YKP79].

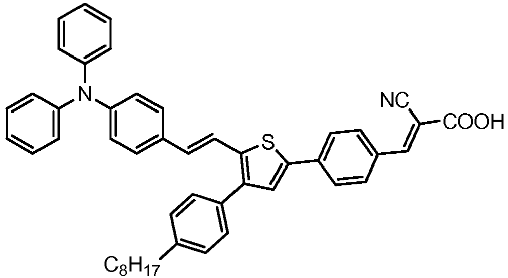

On introduit dans un tricol contenant 10 mL d'un mélange de CH₃CN sous atmosphère d'argon, 80,0 mg (0,124 mmol, 1 eq) de YKP73, 13 mg (0,148 mmol, 1,2 eq) d'acide cyanoacétique et quelques gouttes catalytiques de pyridine. Le tout est porté à reflux pendant 2 h. Ensuite, le CH₃CN est évaporé au rotavapeur et l'ensemble est repris par du CHCl₃. La phase organique est lavée successivement par une solution d'HCl 2 mol.L⁻¹, par de l'eau, puis séchée sur du Na₂SO₄. Le produit désiré précipite dans un mélange d'hexane et d'éther de pétrole. Après filtration, lavage au pentane et séchage à l'étuve, on obtient 79 mg du composé YKP73 sous forme d'un solide rouge (rendement de 89,4%).

### VI. Préparation d'unités indacénothiophène pour la synthèse de colorants ne faisant pas partie de l'invention.

### VI.1. 2,5-di(thiophèn-2-yl)téréphthalate de diéthyle (1).

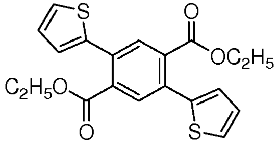

Du 2,5-dibromotéréphtalate de diéthyle (4,27 g, 11,24 mmol) et du bromure de 2-thiénylzinc (0,5 M dans du THF, 50 ml, 25 mmol) sont introduits dans un bicol. La catalyseur palladium tétrakis(triphénylphosphine) (Pd(PPh₃)₄) est ensuite introduit dans le bicol. Le mélange ainsi obtenu est chauffé à reflux (70°C) pendant 3 h. Après un retour à température ambiante, le mélange réactionnel est versé dans une solution saturée de NH₄Cl. Le produit est extrait avec de l'acétate d'éthyle (3 x 100 ml). Les extraits sont combinés et lavés avec de l'eau puis séchés sur du Na₂SO₄. Après filtration, le solvant est éliminé sous pression reduite. Le produit brut est purifié sur colonne de chromatographie (gel de silice, hexane/dichlorométhane, 10:1, v/v)) pour fournir un solide blanc (3,5 g, 80%).

| | |
|---|---|
| *MW*: *RMN ¹H (CDCl₃):* | *386,48 g*/*mol 7,82 (s, 2H), 7,40 (dd, J=4,4 and 1,9Hz, 2H), 7,09-7,05 (m, 4H), 4,24 (q, J=7,2Hz), 1,15 (t, J=7,2Hz).* |

### VI.2. Composé (2).

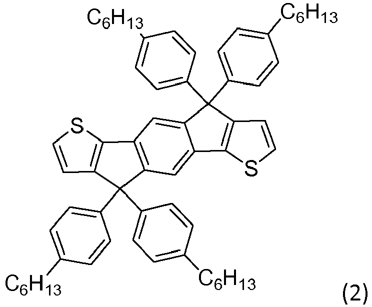

Du 1-bromo-4-hexylbenzène (3 g, 12,5 mmol) est dissous dans 15 ml de THF fraîchement distillé et refroidi à -78°C sous atmosphère d'argon avant addition goutte à goutte d'une solution de n-butyllithium (n-BuLi) (1,6 M dans l'hexane, 8 ml, 12,5 mmol). Le mélange est vigoureusement remué pendant 1 h à -50°C avant l'addition de 2,5-di(thiophen-2-yl)téréphthalate de diéthyle (1) (1 g, 2,6 mmol) dissous dans 10 ml de THF distillé. Après complète addition, le mélange est laissé revenir à température ambiante puis est remué vigoureusement toute une nuit. La réaction est stoppée avec 100 ml d'eau puis le produit est extrait avec de l'acétate d'éthyle (3 X 50 ml) et séché sur du Na₂SO₄. Après élimination du solvant, des solides marrons sont obtenus. Le produit brut est placé dans un bicol de 250 ml et dissous dans 50 ml d'acide acétique. 1 ml de H₂SO₄ concentré est ajouté à la solution et on observe de rapides changements de couleur du jaune au violet puis au vert. Le mélange est chauffé à reflux pendant 2 h. Après 2 h, la couleur tourne au jaune et la solution est versée dans l'eau. Le produit est extrait avec de l'acétate d'éthyle. Après évaporation du solvent, le produit brut est encore purifié sur colonne de chromatographie (gel de silice, hexane/dichlorométhane, 10:1, v/v)). Un solide marron est obtenu (2,08 g, 74%).

| | |
|---|---|
| *MW RMN ¹H (CDCl₃):* | *907,4 g*/*mol 7,42 (2H, s), 7,24 (2H, d, J=4,2Hz), 7,174 (2H, d, J=8,2Hz), 7,064 (2H, d, J=8,2Hz), 7,006 (2H, d, J=4,2Hz), 2,586 (4H, t, J=7,3Hz), 1,543 (8H,m), 1,281 (32H, m), 0,871 (t, 12H)* |

### VI.3. Composé (3).

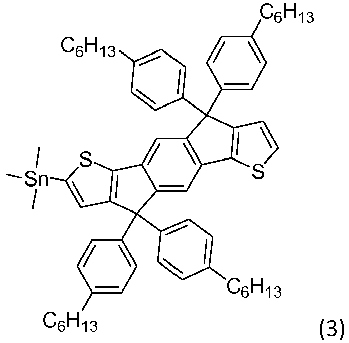

A une solution de (2) (500 mg, 0,55 mmol) dans du THF (30 ml) maintenue à -78°C, une solution de n-BuLi (1,6 M dans de l'hexane, 0,75 ml, 1,2 mmol) est ajoutée goutte à goutte. Le mélange obtenu est vigoureusement remué pendant 1 h à -50°C avant ajout de CISnMe₃ (255 mg, 1,28 mmol) dissous dans 3 ml de THF à -78°C. Le mélange est ramené à la température ambiante et laissé réagir toute la nuit. La réaction dans la solution résultante est alors stoppée avec de l'eau et le produit est extrait avec de l'héxane. La phase organique est séchée sur du Na₂SO₄ et le solvant est évaporé. Un solide marron est obtenu sans autre purification (535 mg, 79%, mono-stannique).

| | |
|---|---|
| *MW* | *1070,21 g*/*mol* |
| *RMN ¹H (CDCl₃):* | *7,408 (1H,s), 7,400 (1H,s), 7,247 (1H, d, J=2,6Hz), 7,222 (1H, d, J=2,6Hz), 7,163 (8H, d, J=8,3Hz), 7,051 (8H, d, J=9,3Hz), 6,979 (1H,s), 2,583 (4H, t, J=7,3Hz), 1,576 (8H,m), 1,276 (32H, m), 0,869 (t, 12H), 0,338 (9H, t)* |

### VI.4. Composé (4).

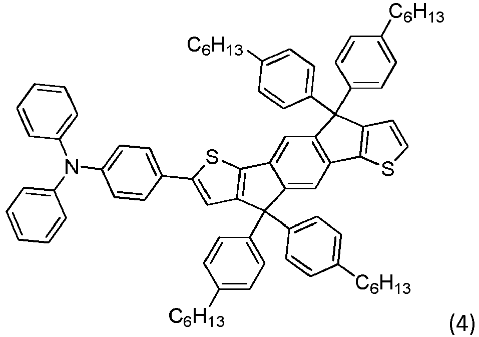

A une solution de (3) (500 mg) dans du DMF (30 mL), est ajouté du bromure de triphénylamine (1 eq), du Pd(PPh₃)₄ à 2% molaire et du K₃PO₄ (1 eq), le mélange est chauffé toute la nuit à 110°C. Le mélange est alors laissé atteindre la température ambiante. La réaction dans la solution résultante est stoppée avec de l'eau et le produit est extrait avec du dichlorométhane. La phase organique est séchée sur du Na₂SO₄ et le solvant est évaporé. Un solide marron est obtenu et le produit brut est purifié sur une colonne de chromatographie pour obtenir le composé (4) (30%).

### VI.5. 3-octyl-5-triméthylstannylthiophène.

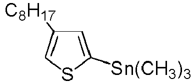

A une solution agitée de 3-octylthiophène (7,50 g, 38,19 mmol) dans 100 mL de THF fraîchement distillé à -78°C, est ajoutée goutte à goutte une solution de n-BuLi (2,5 M, 16,8 mL, 42 mmol). La solution résultante est remuée pendant 45 min et amenée à -50°C. Le mélange est refroidi à -78°C et du CISnMe₃ (8,40 g, 42 mmol) dissous dans 20 mL de THF a été rapidement ajouté. Le mélange résultant est ramené à température ambiante en 80 min et est ensuite versé dans de l'eau, extrait avec du diéthyléther. Les extraits organiques sont lavés avec une solution aqueuse saturée de NH₄Cl. Après séchage et filtration, le filtrat est concentré sous pression réduite pour donner 13,8 g d'un organostannane. A cause de la forte toxicité de ce composé, le produit brut est seulement titré (90% de pureté) par RMN et utilisé sans autre purification.

| | |
|---|---|
| *RMN ¹H (CDCl₃):* | *7,20 (d, J=0,8Hz, 1H), 7,01 (d, J=0,8Hz, 1H), 2,64 (t, 3J=7,4Hz, 2H), 1,62 (tbr, 2 H), 1,35-1,25 (m, 10 H), 0,88 (t, 3J=6,8Hz, 3H), 0,35 (s, 9H).* |

### VI.6. Diéthyl-2,5-bis[4'-octylthien-2'-yl]-1,4-benzènedicarboxylate.

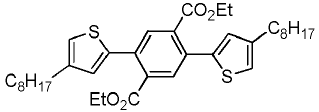

Du diéthyl-2,5-dibromo-1,4-benzènedicarboxylate (2,50 g, 6,57 mmol) et du 3-octyl-5-triméthylstannylthiophène (7,20 g, 18,94 mmol) sont dissous dans du DMF anhydre (75 mL) et le mélange résultant est purgé pendant 10 min avec de l'argon. Séparément, du Pd(OAc)₂ (0,15 g, 0,66 mmol) et du PPh₃ (0,70 g, 2,65 mmol) sont placés dans 5 mL de THF fraîchement distillés et remués 10 min sous argon. Après la formation d'un précipité jaune, le catalyseur est transféré dans la solution de DMF et le mélange est chauffé à 100°C toute la nuit. Le mélange est ensuite filtré à travers de la célite et le DMF est éliminé sous pression réduite. Le produit brut est purifié sur colonne de chromatographie (gel de silice, hexane/CH₂Cl₂, 7:3) pour obtenir 3,85 g (98%) d'une huile transparente.

| | |
|---|---|
| *RMN ¹H (CDCl₃):* | 7,76 (s, 2H), 6,96 (d, 4J=1,4Hz, 2H), 6,91 (d, 4J=1,4Hz, 2H), 4,21 (q, 3J=7,1Hz, 4H, OCH₂), 2,60 (t, 3J=8,0Hz, 4H), 1,65-1,55 (m, 4H), 1,45-1,25 (m, 20H), 1,16 (t, 3J=7,1Hz, 6H, OCH₂CH₃), 0,92-0,85 (m, 6H). |

Analyse élémentaire, trouvé (calculé): C, 70,51 (70,78); H, 8,19 (8,25).

### VI.7. 2,5-bis[4'-octylthien-2'-yl]-1,4-benzène-dicarboxylate (FL46).

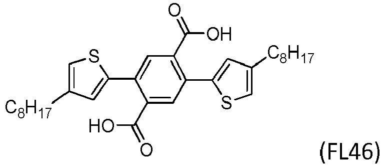

Analyse élémentaire, trouvé (calculé) : C, 69,35 (69,28); H, 7,50 (7,63).

### VI.8. 3,8-dioctyl-4,9-dihydro-s-indaceno[1,2-b:5,6-b']dithiophène-4,9-dione (FL127 ou FL51).

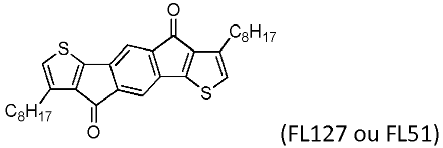

Du 2,5-bis[4'-octylthien-2'-yl]-1,4-benzène-dicarboxylate (1,0 g, 1,80 mmol) est dissous dans 70 mL de CH₂Cl₂ anhydre sous argon. Ensuite, du chlorure d'oxalyle (1,80 mL, 20,5 mmol) et 0,40 mL de DMF sont ajoutés et le mélange est remué 12 h à température ambiante. Le solvant est éliminé sous pression réduite pour obtenir du dichlorure d'acide 2,5-bis[4'-octylthien-2'-yl]-1,4-benzènedicarboxylique qui est utilisé sans autre purification. Le produit est alors dissous dans 80 mL de CH₂Cl₂ anhydre sous argon, puis refroidi à 0°C et une suspension de AlCl₃ (0,72 g, 5,41 mmol) dans 80 mL de CH₂Cl₂ anhydre est ajoutée goutte à goutte. Le mélange est maintenu à 0°C pendant 30 min et est ensuite ramené à température ambiante. Après agitation 3 h à température ambiante, le mélange réactionnel est versé dans de l'eau glacée et de l'acide chlorhydrique à 1 M puis est extrait au chloroforme. La couche organique est lavée avec de l'eau, séchée sur du Na₂SO₄, filtrée et concentrée sous pression réduite sur une colonne de chromatographie (gel de silice, hexane/CHCl₃, 7:3) pour obtenir 0,78 g d'un solide bleu (84%).

| | |
|---|---|
| *RMN ¹H (CDCl₃, 200MHz):* | *7,18 (s, 2H), 6,79 (s, 2H), 2,71 (t, ³J=7,3Hz, 4H), 1,69-1,62 (m, ³J=7,3Hz, 4H), 1,40-1,26 (m, 20H), 0,92-0,84 (m, 6H).* |
| *¹³C NMR (CDCl₃, 50MHz):* | *189,07 (2C=O), 161,15 (2C), 143,85 (2C), 143,54 (2C), 142,49(2C), 142,38 (2C), 127,57 (2C), 117,09 (2C), 34,75 (2C), 32,28 (2C), 32,24 (2C), 32,20 (2C), 32,10 (2C), 31,28 (2C), 25,55 (2C), 17,02 (2C).* |
| *Analyse élémentaire, trouvé (calculé):* | *C, 73,95 (74,09); H, 7,33 (7,38).* |

### VI.9. 2,7-dibromo-3,8-dioctyl-4,9-dihydro-s-indaceno[1,2-b:5,6-b']dithiophene-4,9-dione (FL128).

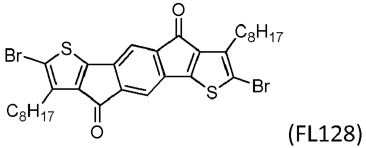

A une solution de 3,8-dioctyl-4,9-dihydro-*s*-indaceno[1,2-b:5,6-b']dithiophène-4,9-dione (1,0 g, 1,92 mmol) dans 30 mL de CHCl₃ et 30 mL d'acide acétique (A_{C}OH), est ajouté du N-Bromosuccinimide (1,04 g, 2,92 mmol) par petites quantités sur une période de 15 min. Le mélange réactionnel est remué 10 h à température ambiante et ensuite il est versé dans de l'eau et extrait avec du CHCl₃. La couche organique est lavée avec du NaHCO₃ et séchée sur du Na₂SO₄. Le produit brut est concentré sous pression réduite et précipité à partir d'hexane. Le filtrat est lavé avec du méthanol et de l'acétone et ensuite séché sous vide pour donner 1,26 g d'un solide bleu (97%).

| | |
|---|---|
| *RMN ¹H (CDCl₃, 200MHz):* | *7,14 (s, 2H), 2,71 (t, ³J=7,0Hz, 4H), 2,61 (t, ³J=7,3Hz, 4H), 1,67-1,50 (m, 4H), 1,25-1,10 (m, 20H), 0,95-0,85 (m, 6H).* |
| *¹³C NMR (CDCl₃, 50MHz):* | *185,28 (2C=O), 156,45 (2C), 139,83 (2C), 139,66 (4C), 138,18 (2C), 114,64 (2C), 113,64 (2C), 32,06 (2C), 29,50 (2C), 29,42 (2C), 29,37 (2C), 29,07 (2C), 27,46 (2C), 22,87 (2C), 14,36 (2C).* |

### VI.10. 2,7-bis(4-octylthien-2-yl)-3,8-dioctyl-4,9-dihydro-s-indaceno[1,2-b:5,6-b']dithiophène-4,9-dione (FL136).

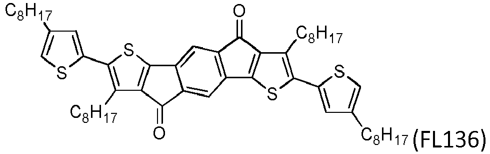

Ce produit est synthétisé à partir de 2,7-dibromo-3,8-dioctyl-4,9-dihydro-*s-*indaceno[1,2-b:5,6-b']dithiophène-4,9-dione (FL128, 0,65 g, 0,96 mmol) et de 3-octyl-5-triméthylstannylthiophène (2,5 eq) selon la méthode de couplage catalysé par le palladium de Stille telle que précdemment décrite. Après quoi, le produit est purifié sur colonne de chromatographie (gel de silice, hexane/CHCl₃, 7:3) pour donner 0,62 g (72%) d'un solide vert-bleu.

| | |
|---|---|
| *RMN ¹H (CDCl₃, 200MHz):* | *7,14 (s, 2H), 6,98 (d, ⁴J=1,2Hz, 2H), 6,94 (d br, 2H), 2,85 (t, ³J=6,8Hz, 4H), 2,61 (t, ³J=7,3Hz, 4H), 1,75-1,52 (m, 8H), 1,45-1,20 (m, 40H), 0,95-0,80 (m, 12H).* |
| *¹³C NMR (CDCl₃, 50MHz):* | *186,57 (2C=O), 155,31 (2C), 143,83 (2C), 140,55 (2C), 140,33 (2C), 139,43 (2C), 136,37 (4C), 134,36 (2C), 127,81 (2C), 120,91 (2C), 114,07 (2C), 31,89 (4C), 30,42 (4C), 29,57 (4C), 29,43 (4C), 29,34 (4C), 29,28 (4C), 22,68 (4C), 14,13 (4C).* |
| *Analyse élémentaire, trouvé (calculé):* | C, 73,85 (74,12); H, 8,14 (8,22); S, 13,95 (14,13). |

### VI.11. 2-bromo-7-(4-(diphenylamino)phényl)-3,8-dioctyl-s-indaceno[1,2-b:5,6-b']dithiophen-4,9(4aH,10aH)-dione [YKP116].

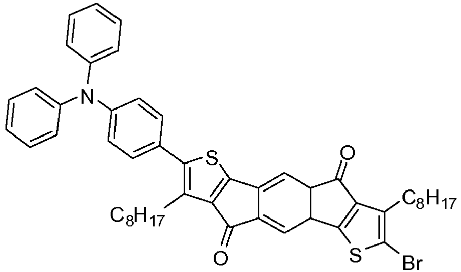

Dans un bicol, on introduit 400 mg (0,59 mmol, 1éq) de composé bromé FL128 et 232 mg (0,65 mmol, 1,1 éq) d'acide 4-(diphénylamino)phénylboronique en présence de 3 éq de K₂CO₄ et 44 mg (4% molaire) de Pd(PPh₃)₄ dans 35 mL de THF, 2,5 mL d'eau et 2 mL de toluène. Le mélange est agité pendant 14 h à 75°C. Après un traitement du mélange avec 100mL d'eau, la phase aqueuse est lavée par 2 × 100 mL d'éther. Les phases organiques sont lavées avec 2 × 100 mL de solution NaCl saturée et séchées sur Na₂SO₄. Après filtration et évaporation du solvant, la purification s'effectue sur colonne de silice avec un éluant [cyclohexane/dichlorométhane : 8/2]. On obtient 210 mg de composé final vert bouteille qui se recristallise dans l'hexane (rendement de 42,24%).

| | |
|---|---|
| *RMN ¹H (CD₂Cl₂):* | *7,32-7,24 (m, 7H), 7,13-7,02 (m, 9H), 2,66 (q, 4H), 1,57 (t, 8H), 1,25 (s, 16H), 085 (t, 6H)* |

### VI.12. 4-(7-(4-(diphénylamino)phényl)-3,8-dioctyl-4,9-dioxo4,4^{a},9,10^{a}-tetrahydro-s-indaceno[1,2-b:5,6-b']dithiophen-2-yl)benzalhyde [YKP121].

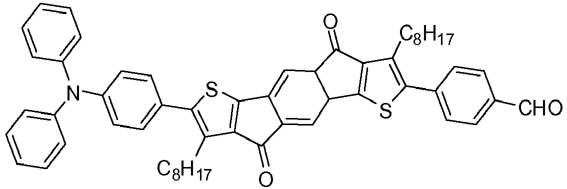

Dans un tricol sous atmosphère d'argon, on introduit 40 mg (0,267 mmol, 1,5 éq) d'acide 4-formylphénylboronique et 150 mg (0,178 mmol, 1éq) de YKP116 en présence de 74 mg (3 eq) de K₂CO₃. Le tout est dissout dans un mélange préalablement dégazé de 0,5 mL d'eau et 15 mL de THF. Après 30 min d'agitation à 60°C, on ajoute 10,3 mg (5% molaire) de Pd(PPh₃)₄ dans le milieu réactionnel. Le tout est agité pendant 14 h à 75°C. Après un traitement du mélange avec 100 mL d'eau, la phase aqueuse est lavée par 2 × 100 mL d'éther. Les phases organiques sont lavées avec 2 × 100 mL de solution NaCl saturée et séchées sur Na₂SO₄. Après filtration et évaporation du solvant, la purification s'effectue sur colonne de silice avec un éluant [hexane/Ether éthylique : 8 /2]. On obtient 60 mg de composé final bleu nuit YKP121 (rendement de 39%).

| | |
|---|---|
| *RMN ¹H (CD₂Cl₂):* | *10 (s, 1H), 7,88 (d, 2H), 7,61 (d, 2H), 7,32-7,24 (m, 7H), 7,13-7,02 (m, 9H), 2,70 (q, 4H), 1,61 (t, 4H), 1,20 (s, 20H), 081 (t, 6H)* |

### VII. Colorants et cellules à électrolyte liquide.

Pour démontrer les avantages d'un colorant fourni dans la description, nous avons utilisé un colorant décrit dans la littérature comme YKP28 particulièrement efficace (9%) et comparé ce dernier au colorant YKP29 dont la structure est modifiée par rapport à celle de YKP28 par introduction d'un thiophène dans le système pi-conjugué.

### VII.1. Matériel et méthodes.

### A. Préparation des dispositifs à électrolyte liquide.

Les films mats de fibres en ZTO (pour « Zinc Tin Oxyde ») ont été rincés avec de l'éthanol puis ensuite frittés à 500°C pendant 30 min. Après refroidissement à 80°C, les électrodes en ZTO ont été immergées dans 3 × 10⁻⁴ Mol.L⁻¹ de cis-di(thiocyanato)-N,N'-bis (2,2'-bipyridyl-4-acide carboxylique-4'-carboxylate de tétrabutylammonium) de ruthénium(II) purifié (N719, Solaronix), de YKP28, et de YKP29 dans de l'éthanol contenant 3 × 10⁻³ Mol.L⁻¹ d'acide déoxycholique (DCA) pendant 15 h à température ambiante.

Pour la contre-électrode, les plaques en FTO (pour « Fluorine-doped Tin Oxide ») ont été alésées par un microforet, lavées avec une solution à 0,1 Mol.L⁻¹ de HCl dans l'éthanol, puis ensuite lavées dans un bain soumis aux ultrasons avec de l'eau et de l'éthanol pendant 15 min. Une contre-électrode de platine a été préparée en coulant par gravité 5 mM de H₂PtCl₆ dans de l'alcool isopropylique sur les plaques en FTO lavées puis ensuite frittée à 400°C pendant 20 min sous air conditionné. Les électrodes en ZTO ayant adsorbé le colorant ont été rincées avec de l'éthanol et séchées sous flux d'azote. Les électrodes en ZTO ayant adsorbé le colorant ont été assemblées et scellées avec la contre-électrode en utilisant des films adhésifs thermiques (Surlyn, Dupont 1702, épaisseur de 25 µm) en tant que cales polymères pour produire des cellules de type
sandwich. L'électrolyte liquide est constitué de 0,7 Mol.L⁻¹ d'iodure de 1-propyl-3-méthylimidazolium, de 0,03 Mol.L⁻¹ d'iode, de 0,1 Mol.L⁻¹ d'iodure de lithium et de 0,5 Mol.L⁻¹ de 4-tert-butylpyridine dans un mélange d'acétonitrile et de valéronitrile (85/15 v/v). Une solution électrolytique a été introduite via un trou fore sur la contre-électrode. Enfin, les trous ont été scellés avec des films thermofusibles et un couvre-objet. La surface typiquement active de la cellule était d'environ 0.36 cm².

### B. Mesures photovoltaïques et photoélectriques.

Les mesures photovoltaïques des DSSC (pour « Dye Sensitized Solar Cells ») ont mis en oeuvre un simulateur solaire (AM 1.5 solar simulator) entre l'échantillon et une lampe excimère au xenon de 450 W. L'intensité de la lumière simulée a été calibrée par une cellule solaire de référence au Si équipée avec un filtre KG5 pour une irradiation globale d'environ AM 1.5. Les caractéristiques photovoltaïques du DSSC ont été obtenues en appliquant une polarisation de potentiel externe aux cellules et en mesurant le photocourant généré avec un compteur de source Keithley modèle 2400. Le rendement de conversion photons incidents à courant incident (IPCE pour « Incident photon-to-current conversion efficiency ») a été mesuré comme une fonction de la longueur d'ondes de 300 nm à 800 nm en utilisant un système IPCE spécialement adapté pour les cellules solaires sensibilisées par un colorant. Une lampe à xénon de 75 W a été utilisée comme source de lumière pour générer un rayon monochromatique. La calibration a été réalisée en utilisant une photodiode de silicium calibrée au NIST (pour « National Institute of Standards and Technology ») comme standard. Les valeurs IPCE ont été collectées à une vitesse de hachage faible de 4 Hz. Les spectres d'impédance électrique ont été mesurés en utilisant un analyseur d'impédance (Solatron 1260) à un potentiel de circuit-ouvert sous une illumination plein soleil AM 1.5 (100 mW/cm²), avec une gamme de fréquences de 0,1^{∼}10⁵ Hz. L'amplitude du signal alternatif était de 10 mV. Les paramètres de l'impédance ont été déterminés en ajustant les spectres d'impédance en utilisant le logiciel Z-plot.

### VII.2. Résultats obtenus.

### A. Spectre d'absorption des colorants.

L'introduction de motifs thiophènes dans la structure du YKP28 permet en effet d'augmenter la délocalisation électronique du système pi-conjugué et a pour résultat de décaler, dans la partie visible du spectre solaire, la bande d'absorption maximale (λmax) et d'augmenter de manière significative le coefficient d'absorption molaire, comme parfaitement illustré Figure 2.

On observe dans ce cas un décalage de 20 nm du spectre d'absorption du colorant en solution éthanol qui passe de 407 nm pour le composé YKP28 à 427 nm pour le composé YKP29. En outre une augmentation du coefficient d'absorption molaire est observée ; un coefficient de 36100 M⁻¹.cm⁻¹ est mesuré dans le cas de YKP28 contre 44600 M⁻¹.cm⁻¹ dans le cas de YKP29 soit une augmentation de 24%.

### B. Rendements de conversion photovoltaïque.

Afin de prouver que les colorants présentant un coefficient d'absorption molaire amélioré permettent d'améliorer les rendements de conversion photovoltaïque, l'utilisation de ces colorants dans des cellules solaires sensibilisées a été réalisée en employant la structure de dispositif suivante :
- Sensibilisation avec le dérivé de ruthénium N719 ou les colorants YKP28 et YKP29 d'une électrode de TiO₂ sur FTO.
- Sertissage avec cales polymère et contre-électrode et remplissage avec électrolyte liquide contenant le couple rédox et, plus particulièrement, le couple redox I⁻ /I³.

Lors de l'optimisation des dispositifs, on observe que l'épaisseur de la couche de TiO₂ peut être réduite de manière significative avec ces colorants organiques qui présentent des coefficients d'absorption molaire élevés. Les performances optimales avec des électrodes de TiO₂ sont obtenues pour une épaisseur d'oxyde de 5 µm dans le cas des colorants organiques contre 12 µm dans le cas du composé de référence à base de ruthénium. Ceci est très avantageux économiquement car une diminution des épaisseurs de TiO₂ permet de diminuer le prix des cellules.

De manière intéressante le composé YKP29 présente des rendements fortement améliorés (Tableau 1 ci-après) et ceci est une conséquence directe de sa capacité améliorée à capter les photons, son coefficient d'absorption molaire étant plus élevé et sa plage d'absorption décalée dans la partie visible.

Le fill factor (FF) est le facteur de remplissage ou encore facteur de qualité : il traduit la capacité de la cellule à évacuer efficacement les charges photogénérées, c'est le rapport entre la puissance maximum qui peut être obtenue avec une cellule sur la puissance réelle.

**Tableau 1**

| **Colorant** | **V_{oc}(mV)** | **J_{sc} (mA/cm²)** | **FF** | **eff (%)** | **surface** |
|---|---|---|---|---|---|
| **N719** | 773 | 17,02 | 0,643 | 9,04 | 0,360 |
| **YKP 28** | 626 | 12,03 | 0,677 | 5,09 | 0,362 |
| **YKP 29** | 646 | 14,34 | 0,687 | 5,96 | 0,357 |

Le fait que les composés à fort coefficients d'absorption molaire montrent des performances meilleures à faible épaisseur de TiO₂ est particulièrement intéressant pour le développement des cellules à électrolyte solide.

En effet, il est possible de remplacer un électrolyte liquide qui comporte de nombreux inconvénients en termes d'application (fuite, corrosion, évaporation) par un électrolyte de type solide conducteur de type p. C'est généralement le composé SpiroOMeTAD qui est classiquement employé comme conducteur de type p **[14].** Dans le cas des dispositifs à électrolyte solide, un facteur limitant concerne la pénétration de l'électrolyte dans la couche d'oxyde mésoporeux. Il est extrêmement difficile d'imprégner par les électrolytes solides des couches d'épaisseurs supérieures à 3 µm. Il est donc avantageux d'utiliser des colorants organiques à fort coefficient d'absorption pour permettre de diminuer l'épaisseur sans pour autant perdre en efficacité de collection de lumière.

### VIII. Colorants et cellules à électrolyte solide.

### VIII.1. Matériel et méthodes.

Des dispositifs à électrolyte solide ont été réalisés avec des colorants fournis dans la description et comparés à une molécule référence du domaine : le D102.

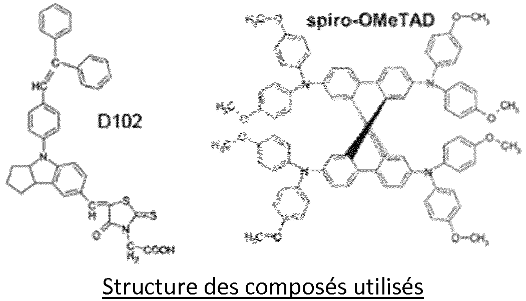

La procédure employée présente les principales étapes suivantes :
- dépôt de couches compactes de TiO₂ (250 nm) (bloqueuse de trous) par pyrolyse en spray sur substrats verre/FTO gravés ;
- dépôt de couches poreuses de TiO₂ à partir d'une colle commerciale de marque DYESOL et traitement thermique de calcination, épaisseur obtenue de 3 µm ;
- sensibilisation avec un dérivé d'Indoline D102 vendu par Mitsubishi Paper Mills (Japon), le colorant YKP28 ou le colorant YKP29, notamment entre 5 et 24 h, idéalement entre 12 et 16 h ;
- remplissage des pores avec le verre moléculaire 2,2',7,7'-tetrakis(N,N-dip-methoxypheny-amine)-9,9'-spirobifluorène désigné « spiro-OMeTAD » (Merck) ;
- dépôt d'une contre-électrode d'or (de quelques centaines de nanomètres) par évaporation sous vide (10⁻⁶ mbar). La surface active est de 0,2 cm².

### VIII.2. Résultats obtenus.

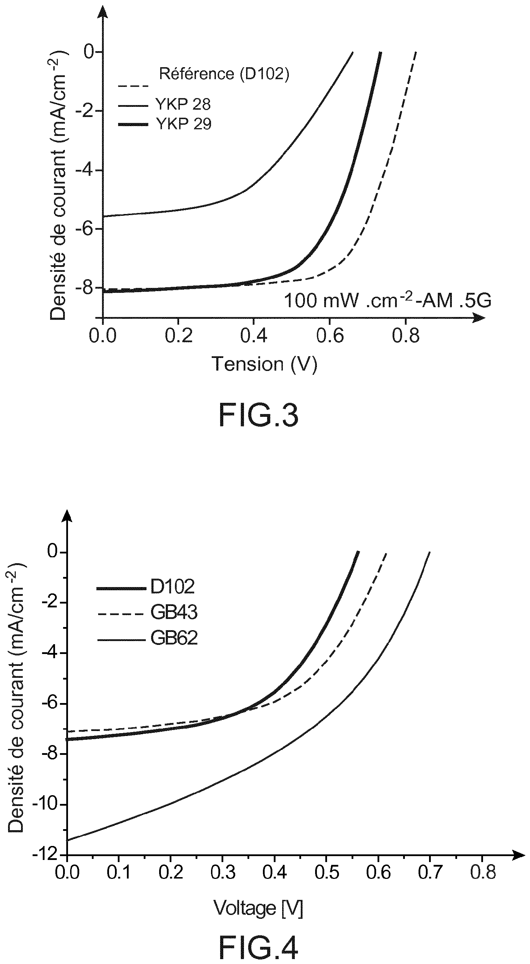

Les résultats obtenus sont présentés à la Figure 3 et dans le Tableau 2 ci-dessous.

**Tableau 2**

| **Colorant** | **V_{oc} (mV)** | **J_{sc} (mA/cm²)** | **FF** | **eff (%)** |
|---|---|---|---|---|
| **D102** | 830 | 8,03 | 0,67 | 4,5 |
| **YKP28** | 670 | 5,56 | 0,48 | 1,8 |
| **YKP29** | 740 | 8,10 | 0,62 | 3,7 |

Des résultats présentés Figure 3 et Tableau 2, il apparaît que la molécule YKP29 permet d'améliorer la densité de courant délivré par les cellules même si le rendement global est inférieur au D102 employé en référence.

On note également que la molécule YKP29 montre des rendements significativement améliorés par rapport à YKP28 molécule publiée en 2008.

### VIII.3. Résultats obtenus avec un autre oxyde métallique.

Cet exemple d'utilisation permet de prouver que les colorants fournis dans la description sont également très efficaces pour la sensibilisation d'autres types d'oxydes métalliques tels que le Zn₂SnO₄.

La première démonstration probante de l'utilisation du Zn₂SnO₄ dans des cellules de type sensibilisées à colorants date de 2007 **[15].** Dans ce travail, c'est le composé organométallique N719 qui est employé en référence et un rendement maximal de 3,7% a été obtenu.

Des cellules avec des électrodes de Zn₂SnO₄ (ZTO) sensibilisées par les colorants YKP28 et YKP29 ont été réalisées et les efficacités ont été comparées avec celle du N719 dans les mêmes conditions. La procédure suivante a été employée :
- dépôt de solutions contenant un polymère et les précurseurs du Zn₂SnO₄ en solution par électrospray sur substrats verre/FTO gravés ;
- traitement thermique de calcination, épaisseur obtenue de 3 µm ;
- sensibilisation avec le dérivé de ruthénium N719 ou nos colorants ;
- sertissage avec cales polymère et contre-électrode et remplissage avec électrolyte liquide contenant le couple redox I⁻/I₃⁻.

Le Tableau 3 ci-après rapporte les efficacités des cellules et démontre la supériorité du colorant YKP29.

**Tableau 3**

| **Colorant** | **V_{oc} (mV)** | **J_{sc} (mA/cm²)** | **FF (%)** | **eff (%)** |
|---|---|---|---|---|
| **N719** | 756 | 2,85 | 65,7 | 1,41 |
| **YKP 28** | 750 | 6,20 | 71,9 | 3,35 |
| **YKP 29** | 717 | 8,11 | 63,2 | 3,67 |

### VIII.4. Autres résultats.

Des résultats préliminaires (non optimisés) obtenus en configuration électrolyte solide avec les molécules selon l'invention (GB043 et GB062) et le dérivé d'Indoline D102 présentés à la Figure 4 et dans le Tableau 4 ci-dessous.

**Tableau 4**

| **Colorant** | **V_{oc} (mV)** | **J_{sc} (mA/cm²)** | **eff (%)** |
|---|---|---|---|
| **D102** | 560 | 7,42 | 2,2 |
| **GB043** | 610 | 7,11 | 2,4 |
| **GB062** | 690 | 11,42 | 3,3 |

Des résultats présentés à la Figure 4 et le Tableau 4, il apparaît que les composés de l'invention présentent des efficacités de conversion photovoltaïque supérieures à la référence D102 testée dans les mêmes conditions. De manière avantageuse, les cellules utilisant les composés de l'invention présentent des tensions de circuit ouvert supérieures à celle de la référence commerciale (D102).

### BIBLIOGRAPHIE

**[1]** O'Regan et Grätzel, 1991, « A low-cost, high-efficiency solar cell based on dye-sensitized colloidal TiO2 films », Nature, vol. 353, pages 737-740.
**[2]** Grätzel, 2009, « Recent advances is mesoscopic solar cells », Acc. Chem. Res., vol. 42, pages 1781-1798.
**[3]** Mishra et al., 2009, « Metal-Free Organic Dyes for Dye-Sensitized Solar Cells: From Structure: Property Relationships to Design Rules », Angew. Chem. Int. Ed., vol. 48, pages 2474-2499.
**[4]** Yan et al., 2010, « Effect of surface etching on the efficiency of ZnO-based dye-sensitized solar cells », Langmuir, vol. 26, pages 7153-7156.
**[5]** Ooyama et Harima, 2009, « Molecular designs and syntheses of organic dyes for dye-sensitized solar cells », Eur. J. Org. Chem., vol. 2009, pages 2903-2934.
**[6]** Wang et al., 2005, « A high molar extinction coefficient sensitizer for stable dye-sensitized solar cells », J. Am. Chem. Soc., vol. 127, pages 808-809.
**[7]** Demande internationale WO 2009/109499 au nom de BASF SE et publiée le 11 septembre 2009.
**[8]** Chen et al., 2007, « Effect of tetrahydroquinoline dyes structure on the performance of organic dye-sensitized solar cells », Chem. Mater., vol. 19, pages 4007-4015.
**[9]** Wu et al., 2010, « Efficient and stable dye-sensitized solar cells based on phenothiazine sensitizers with thiophene units », J. Mater. Chem., vol. 20, pages 1772-1779.
**[10]** Xu et al., 2008, « New triphenylamine-based dyes for dye-sensitivized solar cells », J. Phys. Chem. C, vol. 112, pages 874-880.
**[11]** Liu et al., 2008, « Simple organic molecules bearing a 3,4-ethyledioxythiophene linker for efficient dye-sensitivized solar cells », Chem. Commun., vol. 2008, pages 5152-5154.
**[12]** Zeng et al., 2010, « Efficient dye-sensitivized solar cells with an organic photosensitizer featuring orderly conjugated ethylenedioxythiophene and dithienosilole blocks », Chem. Mater., vol. 22, pages 1915-1925.
**[13]** Chen et al., 2010, « High molecular extinction coefficient branchlike organic dyes containing di(p-tolyl)phenylamine donor for dye-sensitized solar cells applications », J. Phys. Chem. C, vol. 114, pages 3280-3286.
**[14]** Cappel et al., 2009, « Dye regeneration by Spiro-MeOTAD in solid state dye-sensitized solar cells studied by photoinduced absorption spectroscopy and spectroelectrochemistry », J. Phys. Chem. C, vol. 113, pages 6275-6281.
**[15]** Tan et al., 2007, « Zinc stannate (Zn2SnO4) Dye-Sensitized Solar Cells », J. Am. Chem. Soc., vol. 129, pages 4162-4163.
**[16]** Kalyanasundaram K., 2010, « Dye Sensitized Solar Cells », (ed.), EPFL Press, ISBN: 978-2-940222-36-0 CRC Press ISBN 978-1-4398-0866-5.

## Revendications

1. Colorant organique répondant à la structure (I) suivante :
eD - chromophore pi-conjugué - L - A (I)
dans laquelle
- eD représente un segment électro-donneur, ledit segment électro-donneur (eD) étant un groupement amino de type (Z₁)(Z₂)N-, avec Z₁ et Z₂, identiques ou différents, représentant un groupement alkyle éventuellement substitué ou un groupement aryle éventuellement substitué,
un groupement alkyle ou aryle substitué étant un groupement alkyle ou aryle substitué par un groupement ou plusieurs groupements identiques ou différents choisi(s) parmi un halogène; une amine; une diamine; un carboxyle; un carboxylate; un aldéhyde; un ester; un éther ; un hydroxyle; un halogène; un aryle éventuellement substitué ; un alkyle éventuellement substitué ; un amide ; un sulfonyle ; un sulfoxyde ; un acide sulfonique; un sulfonate; un acyle ; un vinyle ; un hydroxyle; un époxy; un phosphonate; un isocyanate; un thiol ; un glycidoxy; un acryloxy; un thiophène ; un furanne ; un sélénophène et leurs sels,
- L représente une liaison covalente ou un segment espaceur, ledit espaceur L étant une chaîne alcénylène ou alcynylène éventuellement substituée ou une chaîne arylène éventuellement substituée,
une chaîne alcénylène, alcynylène ou arylène substituée étant une chaîne alcénylène, alcynylène ou arylène présentant une substitution ou plusieurs substitutions, identiques ou différentes, cette ou ces substitution(s) correspondant à des atomes d'halogène ou à des groupes aliphatiques comprenant éventuellement au moins un hétéroatome,
- A représente un segment électro-attracteur apte à former une liaison covalente avec un semi-conducteur, ledit segment électro-accepteur (A) étant un groupement acide carboxylique, un groupement acide cyanoacrylique, un groupement phosphonique, un groupement dithiocarboïque ou un groupement répondant à l'une quelconque des formules ci-après : 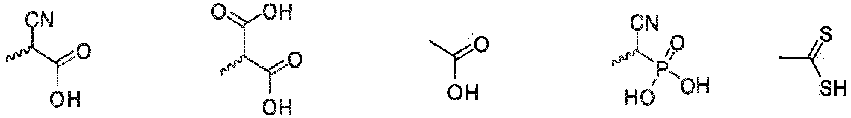 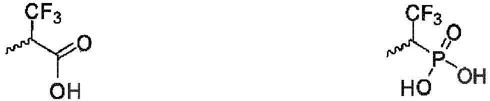 dans lequel le chromophore pi-conjugué comprend au moins deux cycles aromatiques dont au moins un est un cycle de type thiophène,
et dans lequel ce chromophore présente au moins un motif choisi parmi : 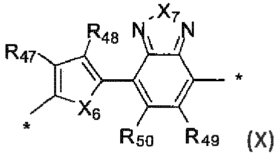 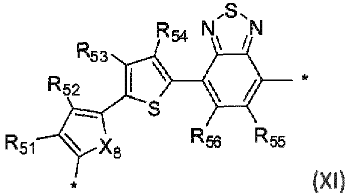 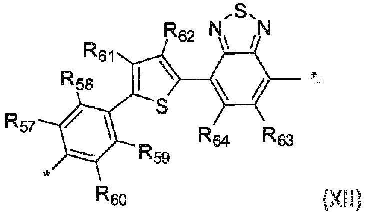 dans lesquels
- les radicaux R₄₇ à R₆₄, identiques ou différents, représentent un hydrogène, un groupement alkyle éventuellement substitué ou un groupement aryle éventuellement substitué ;
- X₈ est choisi parmi S, Se et O ; et
- X₆ et X₇ sont tels que l'un des deux représente S et l'autre est soit Se, soit O.

2. Colorant organique selon la revendication 1, **caractérisé en ce que** ledit colorant comprend un motif correspondant à tout ou partie de l'espaceur L ou à une partie du chromophore pi-conjugué et au segment électro-accepteur (i.e. motif -L-A) répondant à l'une quelconque des formules suivantes :

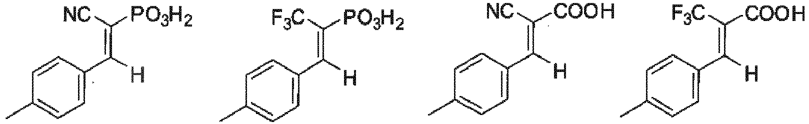

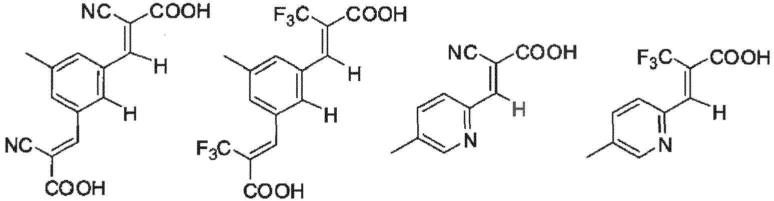

3. Colorant organique selon la revendication 1 ou 2, **caractérisé en ce que** ledit colorant organique est choisi parmi les composés suivants :

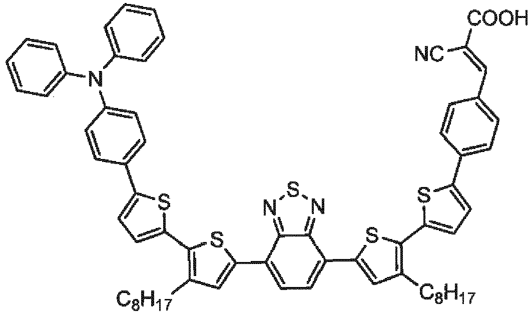

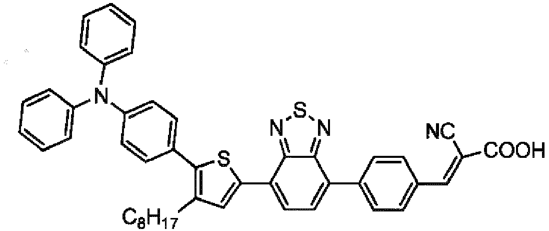

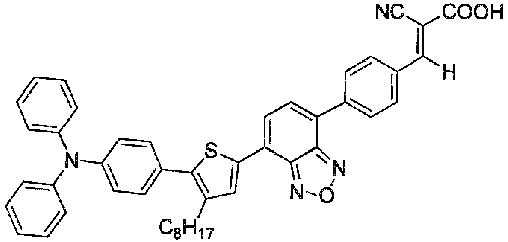

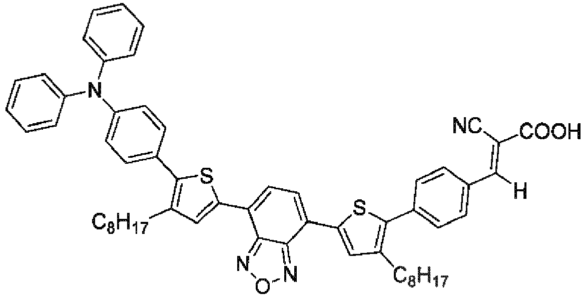

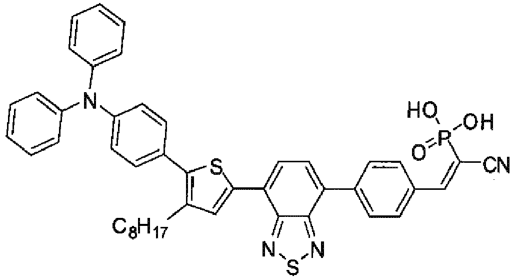

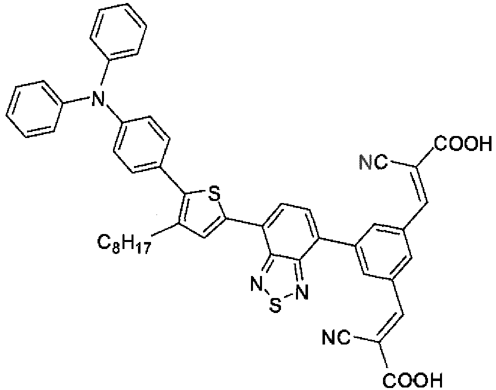

4. Utilisation d'un colorant organique tel que défini dans l'une quelconque des revendications 1 à 3, comme photosensibilisateur dans un dispositif photovoltaïque.

5. Dispositif photovoltaïque présentant une couche d'oxyde métallique semi-conducteur nanostructuré sensibilisée par un colorant organique tel que défini dans l'une quelconque des revendications 1 à 3.

6. Dispositif photovoltaïque selon la revendication 5, **caractérisé en ce que** ledit dispositif photovoltaïque comprend en outre deux électrodes, dénommées anode et contre électrode, et séparées l'une de l'autre par un électrolyte et éventuellement des cales polymères.

7. Dispositif photovoltaïque selon la revendication 5 ou 6, **caractérisé en ce que** ledit oxyde métallique semi-conducteur est un oxyde métallique binaire, tertiaire ou quaternaire.

8. Dispositif photovoltaïque selon l'une quelconque des revendications 5 à 7, **caractérisé en ce que** ladite couche d'oxyde métallique semi-conducteur nanostructuré se présente sous forme d'une couche mésoporeuse déposée sur ladite anode.

9. Dispositif photovoltaïque selon l'une quelconque des revendications 5 à 8, **caractérisé en ce que** ledit électrolyte est un liquide, un liquide ionique, un gel ou un solide.

## Patentansprüche

1. Organischer Farbstoff, welcher der folgenden Struktur (I) entspricht:
eD - pi-konjugierter Chromophor - L - A (I)
wobei
- eD ein Elektronendonorsegment darstellt, wobei das Elektronendonorsegment (eD) eine Aminogruppe vom Typ (Z₁)(Z₂)N- ist, wobei Z₁ und Z₂, identisch oder verschieden, eine gegebenenfalls substituierte Alkylgruppe oder eine gegebenenfalls substituierte Arylgruppe darstellen,
wobei eine substituierte Alkyl- oder Arylgruppe eine Alkyl- oder Arylgruppe ist, die durch eine oder mehrere identische oder verschiedene Gruppen substituiert ist, ausgewählt aus Halogen; Amin; Diamin; Carboxyl; Carboxylat; Aldehyd; Ester; Ether; Hydroxyl; Halogen, gegebenenfalls substituiertem Aryl; gegebenenfalls substituiertem Alkyl; Amid; Sulfonyl; Sulfoxid; Sulfonsäure; Sulfonat; Acyl; Vinyl; Hydroxyl; Epoxid; Phosphonat; Isocyanat; Thiol; Glycidoxy; Acryloxy; Thiophen; Furan; Selenophen und deren Salze,
- L eine kovalente Bindung oder ein Spacersegment darstellt, wobei der Spacer L eine gegebenenfalls substituierte Alkenylen- oder Alkynylenkette oder eine gegebenenfalls substituierte Arylenkette ist,
wobei eine substituierte Alkenylen-, Alkynylen- oder Arylenkette eine Alkenylen-, Alkynylen- oder Arylenkette mit einer Substitution oder mehreren identischen oder unterschiedlichen Substitutionen ist, wobei diese Substitution bzw. diese Substitutionen Halogenatomen oder aliphatischen Gruppen entsprechen, die gegebenenfalls mindestens ein Heteroatom umfassen,
- A ein elektronenziehendes Segment darstellt, das dazu geeignet ist, eine kovalente Bindung mit einem Halbleiter zu bilden, wobei das Elektronenakzeptorsegment (A) eine Carbonsäuregruppe, eine Cyanacrylsäuregruppe, eine Phosphongruppe, eine Dithiocarbgruppe oder eine Gruppe ist, die einer der folgenden Formeln entspricht: 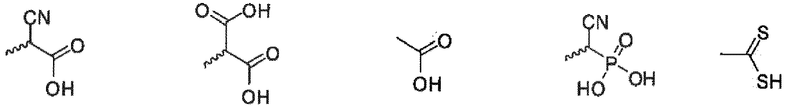 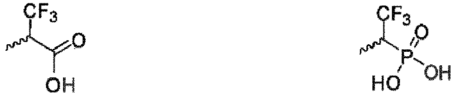 wobei das pi-konjugierte Chromophor zumindest zwei aromatische Ringe enthält, von denen mindestens einer ein Thiophenring ist,
und wobei dieses Chromophor mindestens eine Einheit aufweist, ausgewählt aus: 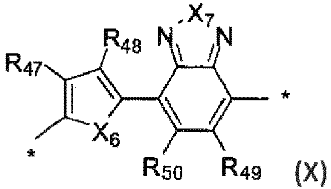 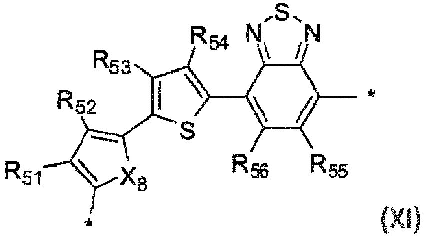 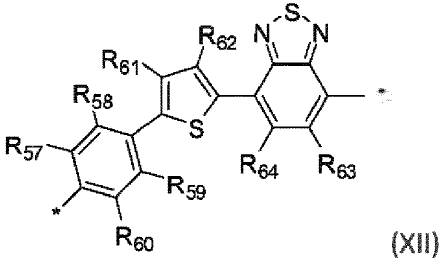 wobei
- die Radikale R₄₇ bis R₆₄, identisch oder verschieden, Wasserstoff, eine gegebenenfalls substituierte Alkylgruppe oder eine gegebenenfalls substituierte Arylgruppe darstellen;
- X₈ ausgewählt ist aus S, Se und O; und
- X₆ und X₇ derart sind, dass eines der beiden S darstellt und das andrere entweder Se oder O darstellt.

2. Organischer Farbstoff nach Anspruch 1, **dadurch gekennzeichnet, dass** der Farbstoff eine Einheit enthält, die ganz oder teilweise dem Spacer L oder einem Teil des pi-konjugierten Chromophors und dem Elektronenakzeptorsegment (d. h. - L - A - Einheit) entspricht, das einer der nachfolgenden Formeln entspricht:

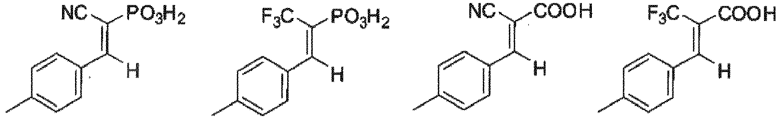

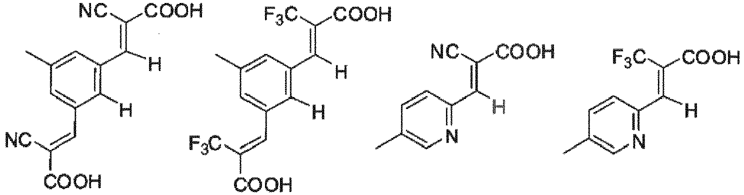

3. Organischer Farbstoff nach Anspruch 1 oder 2, **dadurch gekennzeichnet, dass** der organische Farbstoff ausgewählt ist aus den folgenden Verbindungen:

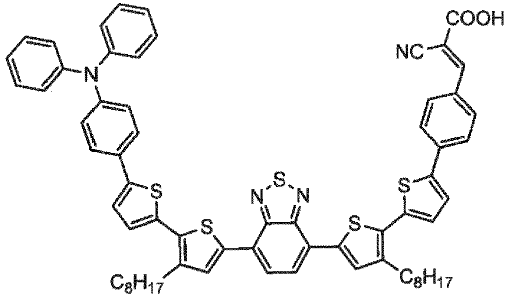

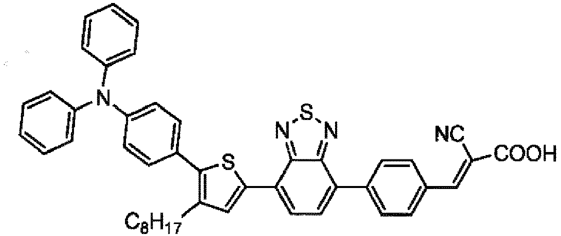

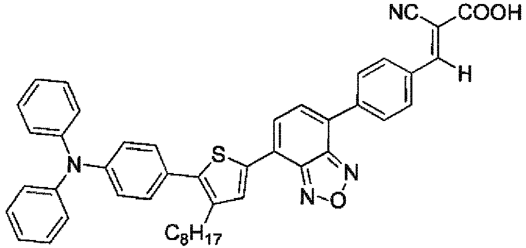

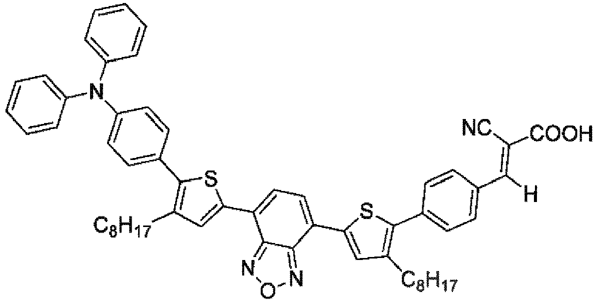

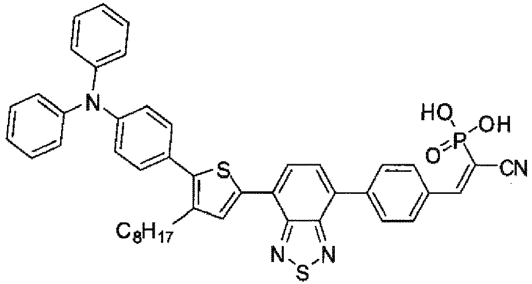

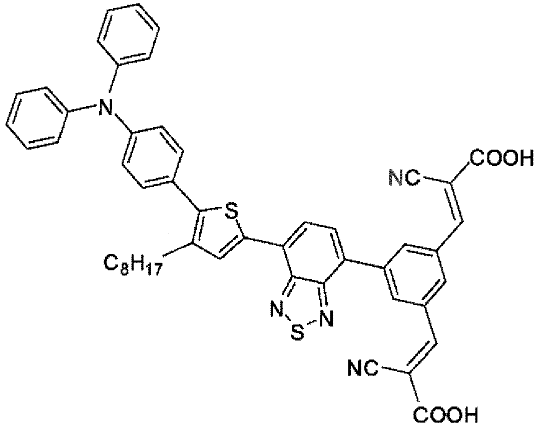

4. Verwendung eines organischen Farbstoffs nach einem der Ansprüche 1 bis 3 als Fotosensibilisator in einer Photovoltaikvorrichtung.

5. Photovoltaikvorrichtung mit einer Schicht aus nanostrukturiertem Halbleitermetalloxid, die mit einem organischen Farbstoff nach einem der Ansprüche 1 bis 3 sensibilisiert ist.

6. Photovoltaikvorrichtung nach Anspruch 5, **dadurch gekennzeichnet, dass** die Photovoltaikvorrichtung ferner zumindest zwei Elektroden enthält, die als Anode und Gegenelektrode bezeichnet werden und durch einen Elektrolyten und gegebenenfalls Polymerkeilen voneinander getrennt sind.

7. Photovoltaikvorrichtung nach Anspruch 5 oder 6, **dadurch gekennzeichnet, dass** das Halbleitermetalloxid ein binäres, tertiäres oder quartäres Metalloxid ist.

8. Photovoltaikvorrichtung nach einem der Ansprüche 5 bis 7, **dadurch gekennzeichnet, dass** die Schicht aus nanostrukturiertem Halbleitermetalloxid in Form einer mesoporösen Schicht, die auf der Anode abgeschieden ist, vorliegt.

9. Photovoltaikvorrichtung nach einem der Ansprüche 5 bis 8, **dadurch gekennzeichnet, dass** der Elektrolyt eine Flüssigkeit, eine ionische Flüssigkeit, ein Gel oder ein Feststoff ist.

## Claims

1. Organic colorant corresponding to the following structure (I):
eD - pi-conjugated chromophore - L - A (I)
in which
- eD represents an electron donor segment, said electron donor segment (eD) being an amino group of (Z₁)(Z₂)N- type, with Z₁ and Z₂, identical or different, representing an alkyl group optionally substituted or an aryl group optionally substituted,
a substituted alkyl or aryl group being an alkyl or aryl group substituted by a group or several groups, identical or different, chosen from a halogen; an amine; a diamine; a carboxyl; a carboxylate; an aldehyde; an ester; an ether; a hydroxyl; a halogen; an aryl optionally substituted; an alkyl optionally substituted; an amide; a sulphonyl; a sulphoxide; a sulphonic acid; a sulphonate; an acyl; a vinyl; a hydroxyl; an epoxy; a phosphonate; an isocyanate; a thiol; a glycidoxy; an acryloxy; a thiophene; a furan; a selenophene and salts thereof,
- L represents a covalent bond or a spacer segment, said spacer L being an alkenylene or alkynylene chain optionally substituted or an arylene chain optionally substituted,
a substituted alkenylene, alkynylene or arylene chain being an alkenylene, alkynylene or arylene chain having one substitution or several substitutions, identical or different, this or these substitutions corresponding to halogen atoms or to aliphatic groups optionally comprising at least one heteroatom,
- A represents an electron attractor segment able to form a covalent bond with a semi-conductor, said electron acceptor segment (A) being a carboxylic acid group, a cyanoacrylic acid group, a phosphonic group, a dithiocarboic group or a group corresponding to any of the following formula: 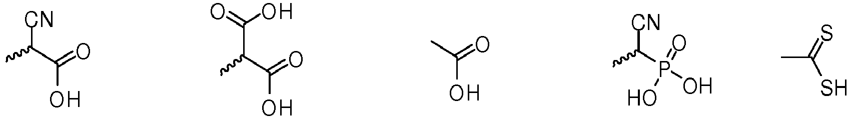 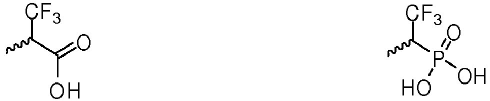 wherein the pi-conjugated chromophore comprises at least two aromatic rings, at least one of which is a thiophene type ring,
and wherein said chromophore has at least one unit chosen from: 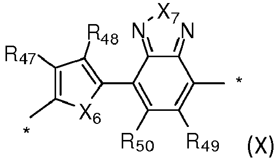 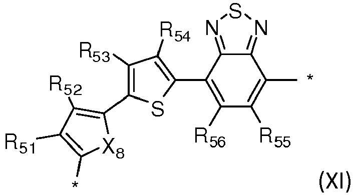 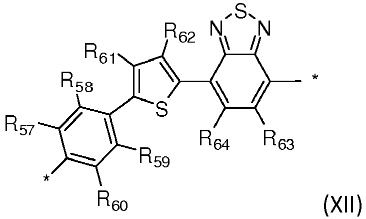 in which
- the radicals R₄₇ to R₆₄, identical or different, represent a hydrogen, an alkyl group optionally substituted or an aryl group optionally substituted,
- X₈ is chosen from S, Se and O, and
- X₆ and X₇ are such that one of the two represents S and the other is either Se, or O.

2. Organic colorant according to claim 1, **characterised in that** said colorant comprises a unit which corresponds to all or part of the spacer L or to a part of the pi-conjugated chromophore or to the electron-accepting segment (i.e. unit-L-A) corresponding to any of the following formulae:

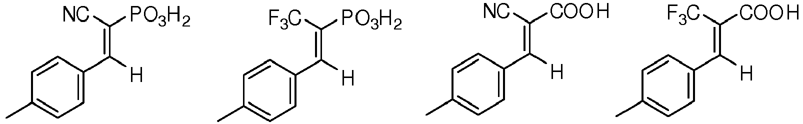

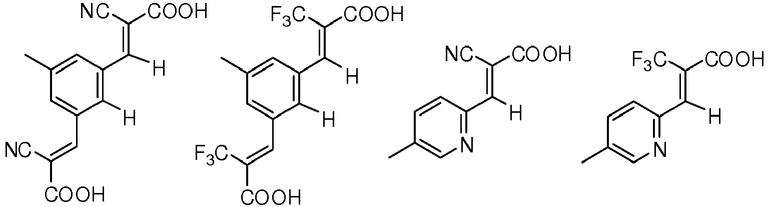

3. Organic colorant according to claim 1 or 2, **characterised in that** said organic colorant is chosen from the following compounds:

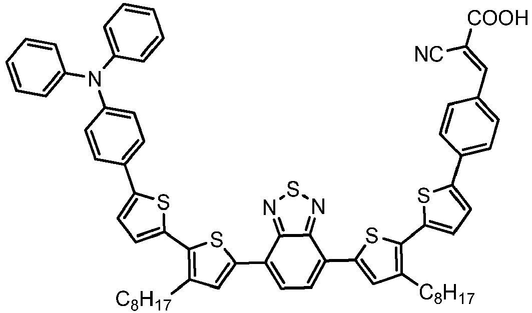

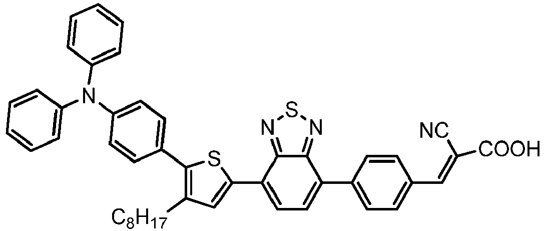

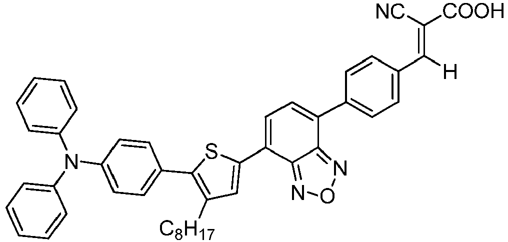

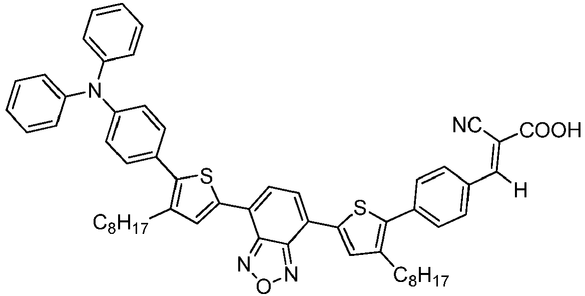

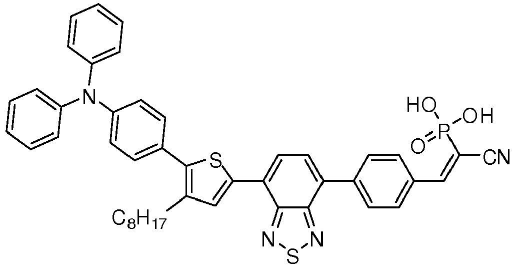

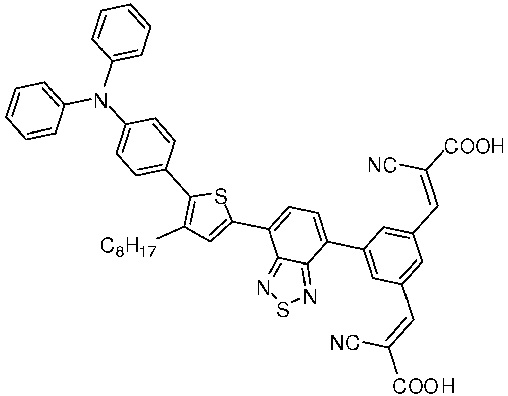

4. Use of an organic colorant as defined in any of claims 1 to 3, as photosensitiser in a photovoltaic device.

5. Photovoltaic device having a nanostructured semi-conductor metal oxide layer sensitised by an organic colorant as defined in any of claims 1 to 3.

6. Photovoltaic device according to claim 5, **characterised in that** said photovoltaic device moreover comprises two electrodes, designated anode and counter electrode, and separated from each other by an electrolyte and optionally polymer shims.

7. Photovoltaic device according to claim 5 or 6, **characterised in that** said semi-conductor metal oxide is a binary, tertiary or quaternary metal oxide.

8. Photovoltaic device according to any of claims 5 to 7, **characterised in that** said nanostructured semi-conductor metal oxide layer is in the form of a mesoporous layer deposited on said anode.

9. Photovoltaic device according to any of claims 5 to 8, **characterised in that** said electrolyte is a liquid, an ionic liquid, a gel or a solid.
